# EUROPEAN PATENT SPECIFICATION

(11) **EP 2 278 041 B1**
(45) Date of publication and mention of the grant of the patent: **23.05.2012**
(21) Application number: 10181976.1
(22) Date of filing: 08.07.2002
(51) Int. Cl.: C23C 14/08, C23C 14/34, H01L 31/18, H01B 5/14

(54) **Sputtering target and transparent conductive film obtainable by the target**
Sputtertarget und durch das Target erhältlicher, transparenter, leitfähiger Film
Cible de pulverisation et film conducteur transparent obtenu par la cible

(30) Priority: 02.08.2001 JP 2001235022; 27.09.2001 JP 2001296089; 27.09.2001 JP 2001297159
(43) Date of publication of application: 26.01.2011
(62) Divisional of application: 02741432.5
(73) Proprietor: Idemitsu Kosan Co., Ltd., Chiyoda-ku Tokyo 100-8321 (JP)
(72) Inventor: Inoue, Kazuyoshi, Sodegaura-shi, Chiba 299-0293 (JP); Matsuzaki, Shigeo, Sodegaura-shi, Chiba 299-0293 (JP)
(74) Representative: Gille Hrabal

(56) References cited:
- US-A- 5 972 527
- EDWARDS D D ET AL: "A new transparent conducting oxide in the Ga2O3-In2O3-SnO2 system" APPLIED PHYSICS LETTERS, vol. 70, no. 13, 31 March 1997 (1997-03-31), pages 1706-1708, XP000689470 AIP, AMERICAN INSTITUTE OF PHYSICS, MELVILLE, NY [US] ISSN: 0003-6951 DOI: 10.1063/1.118676
- SASABAYASHI T ET AL: "Internal stress of ITO, IZO and GZO films deposited by RF and DC magnetron sputtering" MATERIALS RESEARCH SOCIETY SYMPOSIUM - PROCEEDINGS APRIL 16 - 20, 2001, vol. 666, April 2001 (2001-04), pages F241-F246, XP002431394

## Description

### Technical Field

The present invention relates to a sputtering target making it possible to suppress the generation of nodules when a transparent conductive film is formed by sputtering, to attain the formation of the film stably, and a transparent conductive film excellent in etching workability.

### Background Art

Since liquid crystal display devices and electroluminescence display devices are excellent in displayer performance and consume small electric power, they are widely used in display instruments such as portable telephones, personal computers, word processors, and televisions. All of these display instruments have a sandwich structure wherein a display element is sandwiched between transparent conductive films. The main currents of the transparent conductive films used in these display instruments are indium thin oxide (abbreviated to ITO hereinafter) films. This is because the ITO films are excellent in transparency and electric conductivity, can be etched, and further are excellent in adhesiveness to substrates. The ITO films are usually formed by sputtering.

As described above, the ITO film has excellent performance as a transparent conductive film. However, when a target is used to form the film by sputtering, black precipitations (projections) called nodules are generated on the surface of the target. Accordingly, the speed of forming the film is lowered, or discharge voltage rises to cause abnormal discharge. At this time, there arises a problem that the nodules scatter and adhere to the substrate on which the film is formed, thereby causing the incorporation of alien substances into the transparent conductive film. When the nodules are generated, it is necessary to interrupt the operation for forming the film and remove the nodules on the target surface by polishing. For this reason, the productivity of the transparent conductive film is largely lowered.

Thus, in order to prevent alien substances from being incorporated into a transparent conductive film, following the scattering of nodules, without interrupting the operation for forming the transparent conductive film, it has been investigated to set up means for suppressing the generation of abnormal discharge in a power source circuit of a film-forming machine. However, the generation of the nodules has not yet been able to be completely suppressed. Furthermore, in order to suppress the generation of nodules, a target precursor is sintered at high temperature to make the density of the resultant high and decrease pores, thereby producing a target having a theoretical density ratio of about 99%. In this case, however, it is impossible to suppress the generation of nodules completely. Under such a situation, it has been desired to develop a target, for forming a transparent conductive film, making it possible to attain the formation of the film stably without generating any nodule at the time of the film-formation by sputtering.

Furthermore, an ITO film is etching-worked with a strong acid, aqua regia or the like when a circuit pattern is formed after the formation of the film. However, there is caused a problem that it is largely feared that aluminum, which is a wiring material for thin film transistors, is corroded. Thus, it has been desired to develop a transparent conductive film which can be etching-worked without producing any adverse effect on such a wiring material.

US 5, 972, 527 discloses a transparent conductive layer and a sputtering target having a composition in terms of atomic ratio of [In/(In + Zn)] of 0.5 to 0.9. The conductive layer has execellent electrical conductivity. The document does not refer to formation of modules.

An object of the present invention is to provide a sputtering target making it possible to suppress the generation of nodules when a transparent conductive film is formed by sputtering and attain the formation of the film stably, and a process for producing the same.

Another object of the present invention is to provide a transparent conductive film excellent in etching workability, and a process for producing the same.

### Disclosure of the Invention

In order to solve the above-mentioned problems, the present inventors made eager investigation repeatedly. As a result, it has been found out that a nodule generated in a target for forming an ITO film is basically a digging-residue when the surface of the target is sputtered, and the cause that this digging-residue is generated depends on the crystal grain size of a metal oxide which constitutes the target. That is, it has been found out that when the crystal of indium oxide, which is a metal oxide which constitutes the target, gets large to exceed a given grain size, the generation of nodules on the surface of the target increases abruptly. When the target surface is struck off by sputtering, the speed that the target is struck off is varied dependently on the direction of the crystal plane. Thus, irregularities are generated in the target surface. The size of the irregularities depends on the size of crystal grains present in the sintered product. Accordingly, it is considered that in a target made of a sintered product having a large crystal grain size, irregularities thereof get large and nodules are generated from convex portions thereof. On the basis of such a finding, the present invention has been made.

That is, according to the present invention, the following sputtering targets and transparent conductive films can be obtained.
(1) A sputtering target, comprising a sintered product of a metal oxide comprising indium oxide, gallium oxide and zinc oxide, the metal oxide comprising one or more hexagonal crystal lamellar compounds selected from In₂O₃(ZnO)ₘ, wherein m is an integer of 2 to 10, In₂Ga₂ZnO₇, InGaZnO₄, InGaZn₂O₅, InGaZn₃O₆, InGaZn₄O₇, InGaZn₅O₈, InGaZn₆O₉, and InGaZn₇O₁₀, and the sintered product having a composition of 90 to 99% by mass of the indium oxide and 1 to 10% by mass of the total of the gallium oxide and the zinc oxide, and the content by percentage of the gallium oxide being equal to or more than that of the zinc oxide.
(2) The sputtering target according to (1), wherein the sputtering target further comprises tin oxide, and
   the sintered product has a composition of 80 to 90% by mass of the indium oxide, 7 to 12% by mass of the tin oxide, and 3 to 8% by mass of the total of the gallium oxide and the zinc oxide, and
   the content by percentage of the gallium oxide being equal to or more than that of the zinc oxide..
(3) The sputtering target according to (1) or (2), wherein the maximum grain size of crystal of the hexagonal crystal lamellar compound is 5 µm or less.
(4) A transparent conductive film, which is obtainable by sputtering the sputtering target of (1).
(5) A transparent conductive film, which is obtainable by sputtering the sputtering target of (2).
(6) The transparent conductive film according to (5), wherein the transparent conductive film is obtainable by heat treatment at a temperature of 230 °C or higher.
(7) The transparent conductive film according to (5), wherein the transparent conductive film is obtainable by patterning and subsequently subjecting to treatment at a temperature of 230 °C or higher.

Since these sputtering targets are preferably made of crystal having a small grain size, it is possible to suppress the generation of nodules generated in the surface of the target when a transparent conductive film is formed, and conduct sputtering stable.

According to the present invention, the above-mentioned sputtering targets are used to form transparent conductive films by sputtering. As a result, the following transparent conductive films can be obtained.

### Best Modes for Carrying Out the Invention

Embodiments of the present invention are described hereinafter.

### [Embodiment 1] (not according to the invention)

The sputtering target of the present embodiment is a sputtering target comprising indium oxide and tin oxide, the content by percentage of the tin atoms therein being from 3 to 20 atomic% of the total of the indium atoms and the tin atoms, and the maximum grain size of crystal in the sputtering target being 5 µm or less.

The reason why the content by percentage of the tin atoms is set into 3 to 20 atomic% of the total of the indium atoms and the tin atoms is as follows: if this content by percentage of the tin atoms is less than 3 atomic%, the conductivity of the transparent conductive film formed by use of the sputtering target is lowered; and if the content by percentage of the tin atoms is more than 20 atomic%, the conductivity of the transparent conductive film is lowered in the same manner. About the composition of the indium oxide and the tin oxide, the content by percentage of the tin atoms is more preferably from 5 to 15 atomic% of the total of the indium atoms and the tin atoms.

The crystal in the sputtering target of the present embodiment has dense crystal texture having a maximum grain size of 5 µm or less. This maximum grain size of the crystal in the sputtering target means an average value obtained as follows: in the case that the shape of the target is a circle, at the center (1 position) of the circle and intermediate positions (4 positions) between the center on two central lines which cross each other at the circle center and circular circumferences on the lines, that is, at 5 positions in all, or in the case that the target shape is a rectangle, at the center thereof (1 position) and intermediate positions (4 positions) between the center on the diagonal lines of the rectangle and corners thereof, that is, at 5 positions in all, about the maximum crystal grain obtained by magnifying the polished surface of the target 2,500 times and observing a frame 50 µm square in the surface by means of a scanning electron microscope, the maximum size thereof is measured; and then the grain sizes of the maximum grains present in respective frames at the five positions are averaged. For the sputtering target of the present invention, it is more preferable that the maximum grain size of the crystal is 3 µm or less.

The sputtering target of the present embodiment may further comprise, as a third element, an oxide of a metal the valence of which is trivalent or more. The content by percentage of the third element may be from 0.1 to 10 atomic% of all metal atoms. That is, this sputtering target is a sputtering target comprising indium oxide, tin oxide and an oxide of the third element, the content by percentage of the tin atoms therein being from 3 to 20 atomic% of the total of the indium atoms and the tin atoms, the content by percentage of the third element being from 0.1 to 10 atomic% of all metal atoms, and the maximum grain size of crystal in the sputtering target being 5 µm or less.

If this content by percentage of the third element is less than 0.1 atomic% in such a sputtering target, the effect of making the crystal grain size finer by the addition of the oxide of the third element is insufficiently exhibited. If the content by percentage of the third element is more than 10 atomic%, the conductivity of the transparent conductive film obtained by forming the film using the sputtering target is lowered. Furthermore, it is more preferable for this sputtering target that the content by percentage of the third element is from 0.1 to 6 atomic% of all the metal atoms. Preferable examples of the oxide of the third element include one or more metal oxides selected from the group consisting of gallium oxide, germanium oxide, yttrium oxide, scandium oxide, lanthanum oxide, niobium oxide, cerium oxide, zirconium oxide, hafnium oxide and tantalum oxide.

Next, the above-mentioned sputtering target is produced, for example, as follows: the target can be produced by: granulating, by casting or by means of a spray drier, mixing powder obtained by drying fine powder yielded by wet-pulverizing a mixture of indium oxide and tin oxide, sintering the dried fine particles, adding indium oxide and tin oxide newly to the sintered pulverized product and then wet-pulverizing the resultant; press-molding the granulated particles; sintering the molded particles; and then cutting the sintered molded product.

In this process for producing the sputtering target, the mixing and pulverizing of the respective metal oxides as starting materials can be performed using a wet-mixing pulverizer such as a wet ball mill or a bead mill, ultrasonic waves, or the like. In this case, it is preferable that the starting material powder is pulverized in such a manner that the average particle size of the pulverized product will be 1 µm or less. Next, the resultant fine powder is dried and fired. It is advisable that the drying of this fine powder is performed by means of an ordinary drier for powder. About conditions for firing the dried fine powder, under the atmosphere of air or oxygen gas, the firing temperature is set into 1,300 to 1,700°C, preferably 1,450 to 1,600°C, and the firing time is set into 2 to 36 hours, preferably 4 to 24 hours. Furthermore, it is preferable to set the temperature-rising rate at the time of the firing into 2 to 10°C/minute. The sintered product, which has been fired as described above, is pulverized. The pulverizing herein, which may be dry-pulverizing or wet-pulverizing, is performed so as to set the average particle size of the pulverized product to about 0.1 to 3 µm.

Next, to the sintered product powder obtained herein are added new indium oxide and tin oxide. In this case, about the added amount of the indium oxide and tin oxide added newly to the sintered powder, the mass ratio of the former to the latter is from 1:9 to 9:1, preferably from 2:8 to 5:5. Next, this mixture is wet-pulverized. The pulverization of the mixture of the sintered product powder, the indium oxide and the tin oxide is preferably performed to set the average particle size of the pulverized product into about 0.5 to 2 µm.

The thus-obtained pulverized product is injected to a mold and then sintered, or is granulated with a spray drier, press-molded into a molded product, and then sintered the molded product. About sintering conditions in this case, under the atmosphere in air or oxygen gas the sintering temperature is set into 1,300 to 1,700°C, preferably from 1,450 to 1,600°C, and the sintering time is set into 2 to 36 hours, preferably 4 to 24 hours. The temperature-rising rate at the time of the sintering should be set into 2 to 24°C/minute. In order to produce a sputtering target from the resultant sintered molded product, it is advisable to cut this sintered product into a shape suitable for being fitted to a sputtering machine and attach a fitting jig to this.

A sputtering target comprising indium oxide, tin oxide and an oxide of a third element can be produced by granulating, by casting or by means of a spray drier, fine powder obtained by drying fine powder yielded by wet-pulverizing a mixture of the indium oxide, the tin oxide and the oxide of the third element, sintering the dried fine powder, adding indium oxide, tin oxide and an oxide of the third element newly to the sintered pulverized product, and then wet-pulverizing the resultant; press-molding the granulated particles; sintering the molded particles; and then cutting the sintered molded product. Pulverizing conditions and sintering conditions in this case can be made to the same pulverizing and sintering conditions as in the production of the above-mentioned sputtering target, which comprises two components of indium oxide and tin oxide.

Since the thus-obtained sputtering target of the present embodiment is made of the sintered product obtained by mixing and pulverizing starting material indium oxide and tin oxide, sintering the mixture, adding indium oxide and tin oxide newly to the sintered pulverized product, mixing and pulverizing the resultant, molding the pulverized product, and again sintering the molded product, the target has a very dense texture wherein the maximum grain size of crystal is 5 µm or less. This can be considered as follows: at the time of sintering the molded product the powder of the indium oxide and tin oxide added afterward to the primary sintered powder as raw material functions as a sintering aid; therefore, the sintered product having such a dense crystal texture is obtained.

Accordingly, known sputtering targets, which are each made of a sintered product produced by sintering, only one time, a molded product obtained by mixing indium oxide powder and tin oxide powder and then casting the mixture, or granulating the mixture and then press-molding the granulated mixture, have a coarse crystal form wherein the maximum grain size of the crystal is more than 5 µm.

The sputtering target having the above-mentioned structure is used to make it possible to form a transparent conductive film on a substrate by sputtering. The substrate used herein is preferably a highly transparent substrate, and may be a glass substrate, or a film or sheet made of a transparent synthetic resin which has been used so far. As such a synthetic resin, there can be used polycarbonate resin, polymethyl methacrylate resin, polyester resin, polyether sulfone resin, polyarylate resin or like.

When a film is formed by this sputtering, the formation can be performed using various sputtering machines. In particular, a magnetron sputtering machine is preferably used. About conditions when this magnetron sputtering machine is used to form the film by sputtering, the power of plasma is varied dependently on the surface area of the used target or the film thickness of the transparent conductive film to be produced. Usually, the power of the plasma is set into the range of 0.3 to 4 W per cm² of the target surface area and the time for forming the film is set into 5 to 120 minutes, whereby the transparent conductive film having a desired film thickness can be obtained. This film thickness of the transparent conductive film, which is varied in accordance with the kind of the display device, is usually from 200 to 6,000 angstroms, preferably from 300 to 2,000 angstroms.

About the transparency of the thus-obtained transparent conductive film, the light transmissibility thereof is 80% or more about light having a wavelength of 550 nm. Accordingly, this transparent conductive film can be preferably used as a transparent electrode of various display devices for which high transparency and conductivity are required, such as liquid crystal display elements and organic electroluminescence display elements.

### [Embodiment 2] (not according to the invention)

The sputtering target of the present embodiment is a sputtering target comprising a sintered product of a metal oxide comprising 85 to 99% by mass of [A1] (a1) indium oxide, and 1 to 15% by mass of the total of [B] gallium oxide and [C] germanium oxide, wherein the sintered product comprises, as components of the indium oxide, indium oxide wherein gallium atoms are solid-dissolved by substitution and indium oxide wherein germanium atoms are solid-dissolved by substitution.

The indium oxide wherein the gallium atoms are solid-dissolved into indium oxide component by substitution and the indium oxide wherein the germanium atoms are solid-dissolved into indium oxide component by substitution in this sintered product are oxides obtained as follows: when fine powder of indium oxide, gallium oxide and germanium oxide as starting materials are sintered, gallium atoms and germanium atoms are solid-dissolved into some parts of crystal of the indium oxide by substitution. When all of the gallium oxide and the germanium oxide which are used as the sintering starting materials are solid-dissolved into the indium oxide crystal by substitution, the indium oxide crystal comes to grow. When this indium oxide crystal grows in this case so that the grain size thereof exceeds about 10 µm, the generation of nodules increases.

Thus, in the sputtering target of the present embodiment, some parts of the gallium oxide and the germanium oxide, among the sintering starting materials, are solid-dissolved into the indium oxide crystal by substitution, so as to suppress the growth of the indium oxide crystal. The remaining gallium oxide and germanium oxide are present in crystal boundaries of the indium oxide, so as to suppress the growth of the indium oxide crystal still more. By the structure for attaining the suppression, the generation of nodules can be suppressed at the time of sputtering.

The [A1] component in this sputtering target is mainly made of indium oxide, and a part thereof is made of indium oxide wherein gallium atoms are solid-dissolved by substitution and indium oxide wherein germanium atoms are solid-dissolved by substitution. The indium oxide wherein the gallium atoms are solid-dissolved by substitution and the indium oxide wherein the germanium atoms are solid-dissolved by substitution can be identified, for example, by analysis based on EPMA (electron prove micro analysis).

The maximum grain size of the indium oxide crystal wherein the gallium atoms or the germanium atoms are solid-dissolved by substitution means an average value obtained as follows: in the case that the shape of the sputtering target is a circle, at the center (1 position) of the circle and intermediate positions (4 positions) between the center on two central lines which cross each other at the circle center and circular circumferences on the lines, that is, at 5 positions in all, or in the case that the sputtering target shape is a rectangle, at the center thereof (1 position) and intermediate positions (4 positions) between the center on the diagonal lines of the rectangle and corners thereof, that is, at 5 positions in all, about the maximum grain obtained by magnifying the polished surface of the target 2,500 times and observing a frame 50 µm square in the surface by means of a scanning electron microscope, the maximum size thereof is measured; and then the grain sizes of the maximum grains present in respective frames at the five positions are averaged.

It is preferable to use a size controlled into 5 µm or less as the maximum grain size of the indium oxide crystal present in this sputtering target, wherein the gallium atoms or the germanium atoms are solid-dissolved by substitution. This is because if the maximum grain size of the indium oxide crystal wherein the gallium atoms or the germanium atoms are solid-dissolved by substitution is more than 5 µm, indium oxide crystal wherein these metal atoms are not solid dissolved by substitution grows. That is, by setting the maximum grain size of the indium oxide crystal wherein the gallium atoms or the germanium atoms are solid-dissolved by substitution into 5 µm or less, the growth of the indium oxide crystal can be suppressed. The maximum grain size of the indium oxide crystal wherein the gallium atoms or the germanium atoms are solid-dissolved by substitution is more preferably 3 µm or less.

About the content by percentage of each of the components which constitute the sintered product used in the production of this sputtering target, the content by percentage of the [A1] component is set into 85 to 99% by mass, and the content by percentage of the total of the [B] component and the [C] component is set into 1 to 15% by mass. The reason why the content by percentage of the total of the [B] component and the [C] component is set into 1 to 15% by mass as described above is that if the content by percentage of the two components is less than 1% by mass, the rate of the gallium atoms and the germanium atoms solid-dissolved into the indium oxide crystal by substitution is small so that the growth of the indium oxide crystal cannot be sufficiently suppressed. Furthermore, if the content by percentage of the two components is more than 15% by mass, it is difficult to control the grain size of the indium oxide wherein the gallium atoms are solid-dissolved by substitution or the indium oxide crystal wherein the germanium atoms are solid-dissolved by substitution, and further the conductivity of the resultant transparent conductive film is lowered. About the content by percentage of each of the components which constitute this sintered product, the content by percentage of the [A1] component is more preferably set into 90 to 97% by mass, and the content by percentage of the total of the [B] component and the [C] component is more preferably set into 3 to 10% by mass. About the contents by percentage of the [B] component and the [C] component, the content by percentage of the gallium oxide type component of the [B] component is preferably equal to or more than that of the germanium oxide type component of the [C] component because a transparent conductive film excellent in light transmissibility can be obtained. This content by percentage of the [B] component is preferably 1.5 times or more larger than that of the [C] component, more preferably 2 times or more larger than that of the [C] component.

The sputtering target of the present embodiment is also a sputtering target comprising a sintered product of a four-component systems metal oxide comprising 90 to 99% by mass of the total of [A2] (a2) indium oxide and (a3) tin oxide, and 1 to 10% by mass of the total of [B] gallium oxide and [C] germanium oxide, wherein the sintered product comprises, as components of the indium oxide, indium oxide wherein tin atoms are solid-dissolved by substitution, indium oxide wherein gallium atoms are solid-dissolved by substitution, and indium oxide wherein germanium atoms are solid-dissolved by substitution.

The indium oxide wherein the tin atoms are solid-dissolved by substitution, the indium oxide wherein the gallium atoms are solid-dissolved by substitution and the indium oxide wherein the germanium atoms are solid-dissolved by substitution are oxides obtained as follows: when fine powder of indium oxide, tin oxide, gallium oxide and germanium oxide as starting materials are sintered, tin atoms, gallium atoms and germanium atoms therein are solid-dissolved into some parts of crystal of the indium oxide by substitution.

When all of the tin oxide, the gallium oxide and the germanium oxide among these sintering starting materials are solid-dissolved into the indium oxide crystal by substitution, the indium oxide crystal grows so that the generation of nodules comes to increase. Thus, some parts of the tin oxides, the gallium oxide and the germanium oxide are solid-dissolved into the indium oxide crystal by substitution, so as to suppress the growth of the indium oxide crystal. The remaining tin oxide, gallium oxide and germanium oxide are present in crystal boundaries of the indium oxide, so as to suppress the growth of the indium oxide crystal. By the structure for attaining the suppression, the generation of nodules can be suppressed at the time of sputtering.

The [A2] component in this sputtering target is mainly made of indium oxide and tin oxide, and a part of the indium oxide is composed of indium oxide wherein tin atoms are solid-dissolved by substitution, indium oxide wherein gallium atoms are solid-dissolved by substitution and indium oxide wherein germanium atoms are solid-dissolved by substitution. The indium oxide wherein the tin atoms, the gallium atoms or the germanium atoms are solid-dissolved by substitution can be identified, for example, by analysis based on EPMA (electron prove micro analysis).

It is preferable to use a size controlled into 5 µm or less as the maximum grain size of the indium oxide crystal present in this sputtering target made of the four-component system metal oxide, wherein the tin atoms, the gallium atoms or the germanium atoms are solid-dissolved by substitution. This is because if the crystal grain size of the indium oxide crystal wherein these metal atoms are solid-dissolved by substitution is more than 5 µm, indium oxide crystal wherein these metal atoms are not solid-dissolved by substitution grows. That is, by setting the maximum grain size of the indium oxide crystal wherein the tin atoms, the gallium atoms or the germanium atoms are solid-dissolved by substitution into 5 µm or less, the growth of the indium oxide crystal can be suppressed. The maximum grain size of the indium oxide crystal wherein the tin atoms, the gallium atoms or the germanium atoms are solid-dissolved by substitution is more preferably 3 µm or less.

About the content by percentage of each of the components which constitute the sintered product used in the production of this sputtering target, the content by percentage of the [A2] component is set into 90 to 99% by mass, and the content by percentage of the total of the [B] component and the [C] component is set into 1 to 10% by mass. The reason why the content by percentage of the total of the [B] component and the [C] component is set into 1 to 10% by mass as described above is that: if the content by percentage of the two components is less than 1% by mass, the rate of the tin atoms, the gallium atoms or the germanium atoms solid-dissolved into the indium oxide crystal by substitution is small so that the growth of the indium oxide crystal cannot be sufficiently suppressed and further the etching property of the transparent conductive film formed using this sputtering target deteriorates. Moreover, if the content by percentage of the two components is more than 10% by mass, it is difficult to control the grain size of the indium oxide crystal wherein the tin atoms, the gallium atoms or the germanium atoms are solid-dissolved by substitution, and further the conductivity of the resultant transparent conductive film is lowered.

About the content by percentage of each of the components which constitute this sintered product, the content by percentage of the [A2] component is more preferably from 90 to 98% by mass, and the content by percentage of the total of the [B] component and the [C] component is more preferably from 2 to 10% by mass. The content by percentage of the [A2] component is still more preferably from 92 to 97% by mass, and the content by percentage of the total of the [B] component and the [C] component is still more preferably from 3 to 8% by mass.

The content by percentage of the tin oxide type component which is the (a3) component in the [A2] component is preferably from 3 to 20% by mass. This is because: if this content by percentage of the tin oxide type component is less than 3% by mass, the doping effect thereof when the transparent conductive film formed using the sputtering target is subjected to heat treatment is not sufficiently obtained so that the conductivity may not be improved; and if this content by percentage is more than 20% by mass, the crystallization degree is not improved when the transparent conductive film is subjected to heat treatment so that it becomes necessary to raise the temperature of the heat treatment. This content by percentage of the (a3) component is more preferably from 5 to 15% by mass, still more preferably from 5 to 12% by mass.

About the contents by percentage of the [B] component and the [C] component, the content by percentage of the gallium oxide type component of the [B] component is preferably equal to or more than that of the germanium oxide type component of the [C] component because a transparent conductive film excellent in light transmissibility can be obtained. This content by percentage of the [B] component is preferably 1.5 times or more larger than that of the [C] component, more preferably 2 times or more larger than that of the [C] component.

Next, a process for producing the sputtering target of the present embodiment is, for example, as follows: the sputtering target can be produced by granulating, by casting or by means of a spray drier, mixture powder obtained by pulverizing a mixture of indium oxide, gallium oxide and germanium oxide, or additional tin oxide; press-molding the granulated product; sintering the molded product; and then cutting the resultant sintered product. Herein, the mixing and pulverizing of the respective metal oxides as starting materials can be performed using a wet-mixing pulverizer such as a wet ball mill or a bead mill, ultrasonic waves, or the like. Herein, it is preferable that the starting material powder is pulverized in such a manner that the average particle size of the pulverized product will be 1 µm or less.

About conditions for firing the metal oxides, under the atmosphere of air or oxygen gas, the firing temperature is set into 1,300 to 1,700°C, preferably 1,450 to 1,600°C, and the firing time is set into 2 to 36 hours, preferably 4 to 24 hours. It is preferable to set the temperature-rising rate at the time of the firing into 2 to 10°C/minute. Furthermore, in order to produce a sputtering target from the resultant sintered product, it is advisable to cut this sintered product into a shape suitable for being fitted to a sputtering machine and attach a fitting jig to this.

The sputtering target having the above-mentioned structure is used to make it possible to a transparent conductive film on a substrate by sputtering. The substrate and the sputtering machine used herein are the same as in embodiment 1.

The thus-obtained transparent conductive film of the present embodiment is a transparent conductive film comprising a sintered product of a metal oxide comprising 85 to 99% by mass of [A1] (a1) indium oxide, and 1 to 15% by mass of the total of [B] gallium oxide and [C] germanium oxide, wherein the sintered product comprises, as components of the indium oxide, indium oxide wherein gallium atoms are solid-dissolved by substitution and indium oxide wherein germanium atoms are solid-dissolved by substitution.

In this transparent conductive film, the content by percentage of the [A1] component is set into 85 to 99% by mass and the content by percentage of the total of the [B] component and the [C] component is set into 1 to 15% by mass; therefore, excellent transparency and conductivity are exhibited. Additionally, the transparent conductive film is excellent in etching property since the film is amorphous. If the content by percentage of the total of the [B] component and the [C] component is less than 1% by mass, the transparent conductive film becomes crystalline and the etching property thereof deteriorates. If the content by percentage of the total of the [B] component and the [C] component is more than 15% by mass, the conductivity of the transparent conductive film comes to be lowered. As this transparent conductive film, a film wherein the content by percentage of the [A1] component is from 90 to 97% by mass and the content by percentage of the total of the [B] component and the [C] component is from 3 to 10% by mass is preferable since the film has more excellent conductivity and etching property.

The transparent conductive film of the present embodiment is also a transparent conductive film comprising a sintered product of a four-component system metal oxide comprising 90 to 99% by mass of the total of [A2] (a2) indium oxide and (a3) tin oxide, and 1 to 10% by mass of the total of [B] gallium oxide and [C] germanium oxide, wherein the sintered product comprises, as components of the indium oxide, indium oxide wherein tin atoms are solid-dissolved by substitution, indium oxide wherein gallium atoms are solid-dissolved by substitution, and indium oxide wherein germanium atoms are solid-dissolved by substitution.

In this transparent conductive film made of the four-component system metal oxide, the content by percentage of the [A2] component, that is, the total of the (a2) component and the (a3) component is set into 90 to 99% by mass and the content by percentage of the total of the [B] component and the [C] component is set into 1 to 10% by mass; therefore, excellent transparency and conductivity are exhibited. Additionally, the transparent conductive film is excellent in etching property since the film is amorphous. If the content by percentage of the total of the [B] component and the [C] component is less than 1% by mass, the transparent conductive film becomes crystalline and the etching property thereof deteriorates. If the content by percentage of the total of the [B] component and the [C] component is more than 10% by mass, the conductivity of the transparent conductive film comes to be lowered. As this transparent conductive film, a film wherein the content by percentage of the [A2] component is from 90 to 98% by mass and the content by percentage of the total of the [B] component and the [C] component is from 2 to 10% by mass is more preferable, and a film wherein the content by percentage of the [A2] component is from 92 to 97% by mass and the content by percentage of the total of the [B] component and the [C] component is from 3 to 8% by mass is still more preferable.

Furthermore, this transparent conductive film made of the four-component system metal oxide is formed and subsequently the film is subjected to heat treatment at a temperature of 230°C or more, thereby making it possible to yield a transparent conductive film which is crystalline and excellent in conductivity. The heat

### [Embodiment 3]

The sputtering target of the present embodiment is a sputtering target comprising a sintered product of a metal oxide comprising indium oxide, gallium oxide and zinc oxide, the metal oxide comprising one or more hexagonal crystal lamellar compounds selected from the group consisting of In₂O₃(ZnO)ₘ [wherein m is an integer of 2 to 10], In₂Ga₂ZnO₇, InGaZnO₄, InGaZn₂O₅, InGaZn₃O₆, InGaZn₄O₇, InGaZn₅O₈, InGaZn₆O₉, and InGaZn₇O₁₀, and the sintered product having a composition of 90 to 99% by mass of the indium oxide and 1 to 10% by mass of the total of the gallium oxide and the zinc oxide, and the content by percentage of the gallium oxide being equal or more than that of the zinc oxide.

The metal oxide represented by the general formula In_{z}O₃(ZnO)ₘ among the hexagonal crystal lamellar compounds which the metal oxide comprising indium oxide, gallium oxide and zinc oxide contains may be any one of compounds wherein the value of m in this formula is from 2 to 10. Among these, compounds wherein this value of m is from 2 to 7 are more preferable since the volume resistivity thereof is low.

About the composition of the metal oxide comprising indium oxide, gallium oxide and zinc oxide, the content by percentage of the indium oxide is set into 90 to 99% by mass and the content by percentage of the total of the gallium oxide and the zinc oxide is set into 1 to 10% by mass. This is because: if the content by percentage of the total of the gallium oxide and the zinc oxide is less than 1% by mass, the etching workability of the transparent conductive film obtained using the sputtering target comes to be lowered; and if the content by percentage of the total of the gallium oxide and the zinc oxide is more than 10% by mass, the conductivity of the transparent conductive film obtained in this case comes to be lowered. About this composition of the metal oxide, the content by percentage of the indium oxide is more preferably from 90 to 98% by mass and the content by percentage of the total of the gallium oxide and the zinc oxide is more preferably from 2 to 10% by mass, and the content by percentage of the indium oxide is still more preferably from 92 to 97% by mass and the content by percentage of the total of the gallium oxide and the zinc oxide is still more preferably from 3 to 8% by mass.

About the gallium oxide and the zinc oxide contained in this metal oxide, the content by percentage of the gallium oxide is equal to or more than that of the zinc oxide because the transparent conductive film obtained using this sputtering target is excellent in transparency. This content by percentage of the gallium oxide is more preferably 1.5 times or more larger than that of the zinc oxide, still more preferably 2 times or more larger than that thereof.

About the hexagonal crystal lamellar compound contained in this metal oxide, the maximum grain size of crystal thereof is preferably 5 µm or less. This is because by controlling the maximum grain size of the crystal of the hexagonal crystal lamellar compound present in boundaries of crystal of the indium oxide into 5 µm or less in this sintered product of the metal oxide, the growth of the indium oxide crystal adjacent to this is suppressed so that the maximum grain size thereof can be controlled into 10 µm or less. Accordingly, the maximum grain size of the crystal of this hexagonal crystal lamellar compound is more preferably controlled into 3 µm or less. In this case, the maximum grain size of the indium oxide crystal present in the sintered product can be controlled into 7 µm or less. By reducing the grain size of the crystal present in the sintered product of the metal oxide in this way, the generation of nodules can be suppressed when the sputtering target made of this sintered product is used to form a film. As the content by percentage of this hexagonal crystal lamellar compound is made higher, the effect of suppressing the grain size of the indium oxide crystal can be made higher but the conductivity of the transparent conductive film obtained using this sputtering target gets lower. Accordingly, the hexagonal crystal lamellar compound should be formed within such a composition scope that the content by percentage of the total of the gallium oxide and zinc oxide is 10% or less by mass.

The hexagonal crystal lamellar compound in this metal oxide can be identified, for example, by analysis based on X-ray diffractometry and analysis based on EPMA (electron prove micro analysis). The maximum grain size of the crystal of the hexagonal crystal lamellar compound means an average value obtained as follows: in the case that the shape of the sputtering target is a circle, at the center (1 position) of the circle and intermediate positions (4 positions) between the center on two central lines which cross each other at the circle center and circular circumferences on the lines, that is, at 5 positions in all, or in the case that the sputtering target shape is a rectangle, at the center thereof (1 position) and intermediate positions (4 positions) between the center on the diagonal lines of the rectangle and corners thereof, that is, at 5 positions in all, about the maximum grain obtained by magnifying the polished surface of the target 2,500 times and observing a frame 50 µm square in the surface by means of a scanning electron microscope, the maximum size thereof is measured; and then the grain sizes of the maximum grains present in respective frames at the five positions are averaged.

The sputtering target of the present embodiment may be a sputtering target comprising a sintered product of a four-component system metal oxide comprising indium oxide, tin oxide, gallium oxide and zinc oxide, the metal oxide comprising one or more hexagonal crystal lamellar compounds selected from the group consisting of In₂O₃(ZnO)ₘ [wherein m is an integer of 2 to 10], In₂Ga₂ZnO₇, InGaZnO₄, InGaZn₂O₅, InGaZn₃O₆, InGaZn₄O₇, InGaZn₅O₈, InGaZn₆O₉, and InGaZn₇O₁₀, and the sintered product having a composition of 80 to 90% by mass of the indium oxide, 7 to 12% by mass of the tin oxide, and 2 to 8% by mass of the total of the gallium oxide and the zinc oxide.

In the sputtering target comprising the sintered product of the four-component system metal oxide, the content by percentage of the tin oxide component is set into 7 to 12% by mass. This is because: if the content by percentage of the tin oxide is less than 7% by mass, the electric resistance of the sputtering target may not fall sufficiently; and if the content by percentage of the tin oxide is more than 12% by mass, the electric resistance may rise.

The content by percentage of the total of the gallium oxide component and the zinc oxide component in this sputtering target is set into 3 to 8% by mass. This is because: if the content by percentage of the total of the gallium oxide and the zinc oxide is less than 3% by mass, the resultant transparent conductive film crystallizes so that the etching workability thereof comes to deteriorate; and if the content by percentage of the total of the gallium oxide and the zinc oxide is more than 8% by mass, the conductivity of the resultant transparent conductive film comes to fall.

About the composition of the metal oxide in the sputtering target comprising the sintered product of the four-component system metal oxide, the content by percentage of the indium oxide is is from 80 to 90% by mass, the content by percentage of the tin oxide is from 7 to 12% by mass and the content by percentage of the total of the gallium oxide and the zinc oxide is from 3 to 8% by mass.

About the contents by percentage of the tin oxide and the zinc oxide in this sputtering target, it is preferable that the content by percentage of the tin oxide is larger than that of the zinc oxide since the conductivity of the resultant transparent conductive film can be improved. The content by percentage of the tin oxide is more preferably 1.5 times or more larger than that of the zinc oxide, still more preferably 2 times or more larger than that thereof.

About the hexagonal crystal lamellar compound contained in this sputtering target, the maximum grain size of crystal thereof is preferably 5 µm or less. This is because by controlling the maximum grain size of the crystal of the hexagonal crystal lamellar compound present in boundaries of crystal of the indium oxide into 5 µm or less in the sintered product of this metal oxide, the growth of the indium oxide crystal adjacent to this is suppressed so that the maximum grain size thereof can be controlled into 10 µm or less. The maximum grain size of the crystal of this hexagonal crystal lamellar compound is more preferably controlled into 3 µm or less. In this case, the maximum grain size of the indium oxide crystal in the sintered product can be controlled into 7 µm or less. By reducing the grain size of the indium oxide crystal in the sintered product which constitutes the sputtering target in this way, the generation of nodules can be suppressed when a film is formed.

Next, a. process for producing this sputtering target is, for example, as follows: the sputtering target can be produced by granulating, by casting or by means of a spray drier, fine powder obtained by mixing and pulverizing powders of indium oxide, gallium oxide and zinc oxide, or additional tin oxide; press-molding the granulated product; sintering the molded product; and then cutting the sintered product. Herein, the mixing and pulverizing of the respective metal oxides as starting materials can be performed using a wet-mixing pulverizer such as a wet ball mill or a bead mill, ultrasonic waves, or the like. In this case, it is preferable that the starting material powder is pulverized in such a manner that the average particle size of the pulverized product will be 1 µm or less.

About conditions for firing the metal oxides, under the atmosphere of air or oxygen gas, the firing temperature is set into 1,300 to 1,700°C, preferably 1,450 to 1,600°C, and the firing time is set into 2 to 36 hours, preferably 4 to 24 hours. Furthermore, it is preferable to set the temperature-rising rate at the time of the firing into 2 to 10°C/minute. Furthermore, in order to produce a sputtering target from the resultant sintered product, it is advisable to cut this sintered product into a shape suitable for being fitted to a sputtering machine and attach a fitting jig to this.

The sputtering target having the above-mentioned structure is used to make it possible to form a transparent conductive film on a substrate by sputtering. The substrate and the sputtering machine used herein are the same as in embodiment 1.

The thus-obtained transparent conductive film of the present embodiment is a film comprising a metal oxide comprising indium oxide, gallium oxide and zinc oxide, the metal oxide having a composition of 90 to 99% by mass of the indium oxide and 1 to 10% by mass of the total of the gallium oxide and the zinc oxide.

Since this transparent conductive film is made of the metal oxide having the composition of 90 to 99% by mass of the indium oxide and 1 to 10% by mass of the total of the gallium oxide and the zinc oxide, excellent transparency and conductivity are exhibited. Additionally, the transparent conductive film is excellent in etching property since the film is amorphous. If the content by percentage of the total of the gallium oxide and the zinc oxide is less than 1% by mass, the transparent conductive film becomes crystalline and the etching property thereof comes to deteriorate. If the content by percentage of the total of the gallium oxide and the zinc oxide is more than 10% by mass, the conductivity of the transparent conductive film comes to be lowered. As this transparent conductive film, a film having a composition of 90 to 98% by mass of the indium oxide and 2 to 10% by mass of the total of the gallium oxide and the zinc oxide is preferable since the film has more excellent conductivity and etching property. A film having a composition of 92 to 97% by mass of the indium oxide and 3 to 8% by mass of the total of the gallium oxide and the zinc oxide is more preferable.

The transparent conductive film of the present embodiment may be a film comprising a four-component system metal oxide comprising indium oxide, tin oxide, gallium oxide and zinc oxide, the metal oxide having a composition of 80 to 90% by mass of the indium oxide, 7 to 12% by mass of the tin oxide, and 3 to 8% by mass of the total of the gallium oxide and the zinc oxide.

This transparent conductive film comprising the four-component system metal oxide is made of the metal oxide having the composition of 80 to 90% by mass of the indium oxide, 7 to 12% by mass of the tin oxide, and 3 to 8% by mass of the total of the gallium oxide and the zinc oxide, thereby exhibiting excellent transparency and conductivity. Furthermore, the film is excellent in etching property since the film is amorphous. The reason why the content by percentage of the tin oxide in this transparent conductive film is set into 7 to 12 % by mass is that: if this content by percentage of the tin oxide is less than 7% by mass, the electric resistance of the transparent conductive film may not fall; and if the content by percentage of the tin oxide is more than 12% by mass, the electric resistance may rise.

About this transparent conductive film comprising the four-component system metal oxide, it is preferable that the content by percentage of the tin oxide is larger than that of the zinc oxide since the conductivity is excellent. The content by percentage of the tin oxide in this transparent conductive film is more preferably 1.5 times or more larger than that of the zinc oxide, still more preferably 2 times or more larger than that thereof.

The content by percentage of the total of the gallium oxide and the zinc oxide in the transparent conductive film comprising the metal oxide is set into 3 to 8% by mass. This is because: if this content by percentage is less than 3% by mass, the transparent conductive film becomes crystalline and the etching property thereof comes to deteriorate; and if this content by percentage is more than 8% by mass, the conductivity of the transparent conductive film comes to be lowered.

Furthermore, this amorphous transparent conductive film comprising the four-component system metal oxide is formed and subsequently the film is subjected to heat treatment at a temperature of 230°C or more, thereby making it possible to yield a transparent conductive film which is crystalline and excellent in conductivity. The heat treatment temperature in this case is preferably 250°C or more, more preferably 260°C or more. However, the temperature is usually not more than 300°C. It is advisable that the heat treatment time in this case is set into 0.1 to 5 hours. This heat treatment is preferably conducted after the amorphous transparent conductive film formed using the sputtering target is patterned. This patterning treatment can be conducted by an ordinary method such as photolithography.

The thus-obtained transparent conductive film has a light transmissibility of 75% about light having a wavelength of 400 nm and a light transmissibility of 90% about light having a wavelength of 550 nm, and is excellent in transparency. Additionally, this film has a high conductivity and a work function of 4.6 electron volts or less; therefore, it is possible to control the connection resistance thereof to the electron injection layer of an organic electroluminescence element into a low value. Accordingly, this transparent conductive film can be preferably used in a transparent electrode of various display devices for which high transparency and conductivity are required, such as liquid crystal display elements and organic electroluminescence display elements.

### [Example 1] not according to the invention)

### (1) Production of a sputtering target

At a ratio of indium oxide powder to tin oxide powder, as starting materials, of 90 parts by mass to 10 parts by mass, the two metal oxides were supplied into a wet ball mill, and they were mixed and pulverized for 10 hours to yield raw material powder having an average particle size of 2 µm.

Next, the resultant raw material was dried and granulated with a spray drier, put into a firing furnace and then sintered at 1400°C for 4 hours. The resultant sintered product was pulverized with a crusher, and then pulverized with a hammer mill and a jet mill to yield sintered product powder having an average particle size of 6 µm.

Next, to the sintered product powder yielded herein were newly added 30 parts by mass of indium oxide powder and 3.3 parts by mass of tin oxide powder, and then the whole volume thereof was supplied into a wet ball mill. They were mixed and pulverized for 24 hours to yield mixed powder having an average particle size of 2 µm.

Next, this mixed powder was dried and granulated with a spray drier, and molded into a disc having a diameter of 10 cm and a thickness of 5 mm with a press-molding machine. This disc was put into a firing furnace and sintered at a sintering temperature of 1500°C under the atmosphere of pressured oxygen gas for 8 hours.

In the thus-obtained sintered body, the content by percentage of the tin atoms was 9.3 atomic% of the total of the indium atoms and the tin atoms. The surface of this sintered product was polished and then photographs thereof magnified 2,500 times were taken with a scanning electron microscope at the center (1 position) of the disc and intermediate positions (4 positions) between the center on two central lines which crossed each other at the circle center and circular circumferences on the lines, that is, at 5 positions in all. About the maximum crystal grain observed in a frame 50 µm square thereof, the maximum grain size was measured. The average value of the maximum sizes of the maximum crystal grains present in frames at these 5 positions was calculated. As a result, the average value was 2.8 µm. This sintered product had a density of 7.0 g/cm³. This corresponded to 98% of the theoretical density ratio. The bulk resistance value of this sintered product measured by a four-probe method was 0.61 × 10⁻³ Ω·cm.

The thus-obtained sintered product was cut to produce a sputtering target having a diameter of about 10 cm and a thickness of 5 mm. The measurement results of the composition and physical properties of this sputtering target are shown in Table 1.

### (2) Observation whether nodules were generated or not

The sputtering target obtained in the above-mentioned (1) was adhered to a plate made of copper, and the resultant was attached to a DC magnetron sputtering machine. As the atmosphere therein, a mixed gas wherein 3% hydrogen gas was added to argon gas was used to perform sputtering continuously for 30 hours. About conditions for the sputtering in this case, the pressure, the arrival pressure, the substrate temperature and the applying electric were set to 3 × 10⁻¹ Pa, 5 × 10⁻⁴ Pa,25°C and 100 W, respectively. The hydrogen gas added to the atmospheric gas was for promoting the generation of nodules.

There was adopted a method of magnifying a change in the target surface after the sputtering 50 times and observing the change by means of a stereoscopic microscope, and calculating the number average of nodules 20 µm or more in size generated in a visual field 3 mm² in size. As a result, the generation of nodules in the surface of the sputtering target used herein was not observed.

### (3) Production of a transparent conductive film

The sputtering target obtained in the above-mentioned (1) was attached to a DC magnetron sputtering machine, and a transparent conductive film was formed on a glass substrate at room temperature. About conditions for the sputtering herein, a mixed gas wherein a small amount of oxygen gas was incorporated into argon gas was used as the atmosphere, and the sputtering pressure, the arrival pressure, the substrate temperature, the applying electric power and the time for forming the film were set to 3 × 10⁻¹ Pa, 5 × 10⁻⁴ Pa, 25°C, 100 W, and 20 minutes, respectively.

As a result, obtained was a transparent conductive glass wherein a transparent conductive film having a film thickness of about 2,000 angstroms was formed on the glass substrate.

### (4) Evaluation of the transparent conductive film

About the conductivity of the transparent conductive film on the transparent conductive glass obtained in the above-mentioned (3), the specific resistance of the transparent conductive film was measured by a four-probe method. As a result, it was 240 × 10⁻⁶ Ω·cm. About the transparency of this transparent conductive film, the light transmissibility thereof was 90% about light having a wavelength of 550 mm in accordance with a spectrometer. Thus, the film was also excellent in transparency.

### [Example 2] (not according to the invention)

### (1) Production of a sputtering target

The ratio among used starting materials was set as follows: 85 parts by mass of indium oxide, 10 parts by mass of tin oxide, and 5 parts by mass of gallium oxide, as an oxide of a third element. In this way, raw material powder was prepared. This was sintered and then pulverized in the same way as in the (1) in Example 1.

Next, to the resultant sintered product powder were newly added 25.5 parts by mass of indium oxide, 3 parts by mass of tin oxide and 1.5 part by mass of gallium oxide, and the resultant was pulverized to yield mixed powder. Thereafter, a sintered product was yielded in the same way as in the (1) in Example 1. The measurement results of the composition and physical properties of a sputtering target obtained by cutting this sintered product are shown in Table 1.

### (2) Production of a transparent conductive film

A transparent conductive film was produced in the same way as in the (3) in Example 1 except that the sputtering target obtained in the above-mentioned (1) was used.

### (3) Observation whether the generation of nodules was observed or not, and Evaluation of the transparent conductive film

The same operations as the (2) and the (4) in Example 1 were conducted. The results are shown in Table 1.

### [Example 3] (not according to the invention)

### (1) Production of a sputtering target

The ratio among used starting materials was set as follows: 85 parts by mass of indium oxide, 10 parts by mass of tin oxide, and 5 parts by mass of cerium oxide, as an oxide of a third element. In this way, raw material powder was prepared. This was sintered and then pulverized in the same way as in the (1) in Example 1.

Next, to the resultant sintered product powder were newly added 25.5 parts by mass of indium oxide, 3 parts by mass of tin oxide and 1.5 part by mass of cerium oxide, and the resultant was pulverized to yield mixed powder. Thereafter, a sintered product was yielded in the same way as in the (1) in Example 1. The measurement results of the composition and physical properties of a sputtering target obtained by cutting this sintered product are shown in Table 1.

### (2) Production of a transparent conductive film

A transparent conductive film was produced in the same way as in the (3) in Example 1 except that the sputtering target obtained in the above-mentioned (1) was used.

### (3) Observation whether the generation of nodules was observed or not, and Evaluation of the transparent conductive film

The same operations as the (2) and the (4) in Example 1 were conducted. The results are shown in Table 1.

### [Comparative Example 1]

### (1) Production of a sputtering target

At a ratio of indium oxide powder to tin oxide powder, as starting materials, of 90 parts by mass to 10 parts by mass, the two metal oxides were supplied into a wet ball mill, and they were mixed and pulverized for 10 hours to yield raw material powder having an average particle size of 2 µm.

Next, the resultant raw material was dried and granulated with a spray drier, and then molded into a disc having a diameter of 10 cm and a thickness of 5 mm by means of a press-molding machine. This disc was put into a firing furnace and then sintered at 1500°C under the atmosphere of pressured oxygen gas for 8 hours. The sintered product was cut to yield a sputtering target.

### (2) Production of a transparent conductive film

A transparent conductive film was produced in the same way as in the (3) in Example 1 except that the sputtering target obtained in the above-mentioned (1) was used.

### (3) Observation whether the generation of nodules was observed or not, and Evaluation of the transparent conductive film

The same operations as the (2) and the (4) in Example 1 were conducted. The results are shown in Table 1.

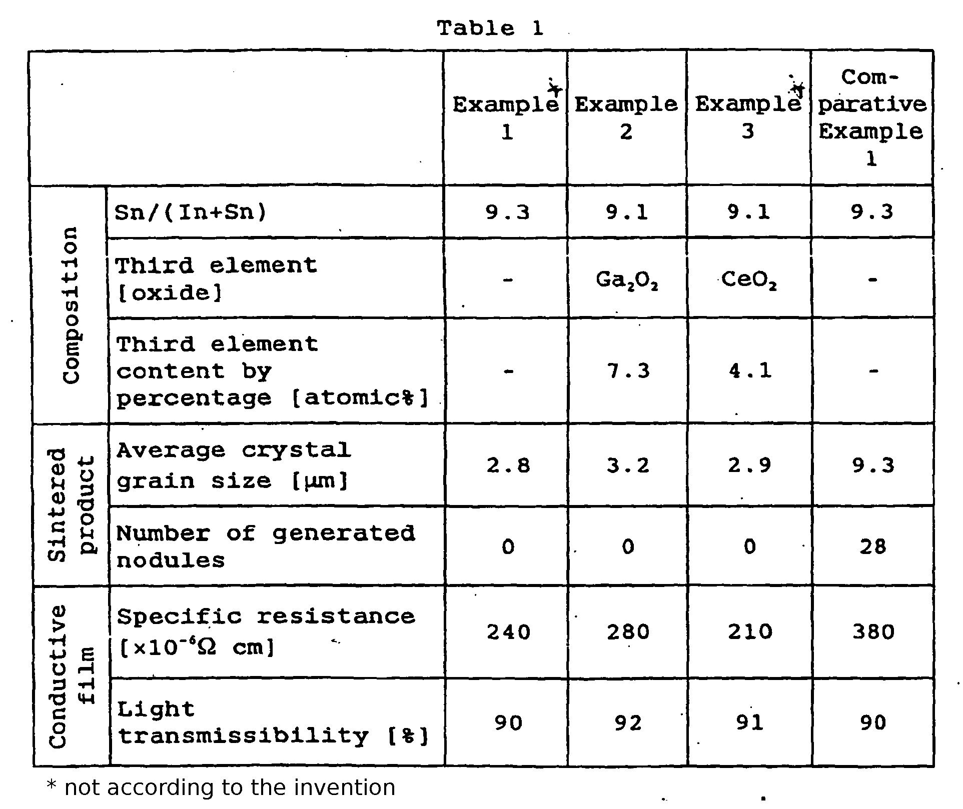

### [Example 4] (not according to the invention)

### (1) Production of a sputtering target

At a ratio of indium oxide powder to gallium oxide powder to germanium oxide powder, as starting materials, of 86 parts by mass to 10 parts by mass to 4 parts by mass, the metal oxides were supplied into a wet ball mill, and they were mixed and pulverized for 10 hours to yield raw material powder having an average particle size of 1.8 to 2 µm. Next, the resultant raw material was dried and granulated with a spray drier, and the resultant particles were filled into a mold and molded under pressure by means of a pressing machine to yield a disc-form molded product having a diameter of 10 cm and a thickness of 5 mm.

Next, this molded product was put into a firing furnace and then sintered under the atmosphere of pressured oxygen gas for 6 hours while the sintering temperature was controlled into 1420 to 1480°C.

About the thus-obtained sintered product, the composition thereof was analyzed. As a result, the content by percentage of the [A1] component was 86% by mass, the content by percentage of the [B] component was 10% by mass, and the content by percentage of the [C] component was 4% by mass. This sintered product was analyzed by EPMA. As a result, it was proved that indium oxide crystal wherein gallium atoms were solid-dissolved by substitution and indium oxide crystal wherein germanium atoms were solid-dissolved by substitution were present. Additionally, it was proved that gallium oxide wherein indium atoms were solid-dissolved by substitution and germanium oxide wherein indium atoms were solid-dissolved by substitution were present. At the center (1 position) of the disc-form sintered product and intermediate positions (4 positions) between the center on two central lines which crossed each other at the circle center and circular circumferences on the lines, that is, at 5 positions in all thereof, the sintered product was magnified 2,500 times and photographed with a scanning electron microscope. About the maximum crystal grain observed in a frame 50 µm square thereof, the maximum grain size thereof was measured. The average value of the maximum grain sizes of the maximum crystal grains present in frames at these 5 positions was calculated. As a result, it was 2.3 µm. The density of this sintered product was 6.65 g/cm³. This corresponded to 96% of the theoretical density ratio. Furthermore, the bulk resistance value of this sintered product, measured by a four-prove method, was 3.8 × 10⁻³ Ω·cm.

The thus-obtained sintered product was cut to produce a sputtering target having a diameter of about 10 cm and a thickness of about 5 mm.

### (2) Observation whether the generation of nodules was observed or not

The sputtering target was observed in the same way as in the (2) in Example 1.

As a result, the generation of nodules was not observed in the surface of the sputtering target used herein.

The composition and physical properties of the sputtering target produced herein, and observation results as to whether nodules were generated or not are shown in Table 2.

### (3) Production of a transparent conductive film

A transparent conductive film was produced in the same way as in the (3) in Example 1.

As a result, there was obtained a transparent conductive glass wherein a transparent conductive film having a film thickness of about 2,000 angstroms was formed on a glass substrate.

### (4) Evaluation of the transparent conductive film

The transparent conductive film on the transparent conductive glass, which was obtained in the above-mentioned (3), was evaluated about the following items. The results are shown in Table 3.

### 1) Conductivity

About the conductivity, the specific resistance of the transparent conductive film was measured by a four-prove method. As a result, the value of the specific resistance was 480 × 10⁻⁶ Ω·cm.

### 2) Transparency

About the transparency, the light transmissibility was measured with a spectrometer. As a result, the light transmissibility was 78% about light having a wavelength of 400 nm. The light transmissibility was 91% about light having a wavelength of 550 nm.

### 3) Crystallinity

The crystallinity was measured by X-ray diffractometry. As a result, this transparent conductive film was amorphous.

### 4) Etching property

About the etching property, an aqueous oxalic acid solution having a concentration of 3.5% by mass was used as an etching solution, so as to carry out a test at 30°C. The state of an etched surface of the transparent conductive film after etching was observed with a stereoscopic micrometer. As a result, it was proved that no residue of the transparent conductive film was present on the etched surface of the film.

The same operation as described above was performed except that a mixed acid of nitric acid:phosphoric acid:acetic acid:water = 2:17:1800:1000 was used as the etching solution, so as to evaluate the etching property. As a result, it was proved that no residue of the transparent conductive film was present on the etched surface of the film.

### 5) Work function

The work function was measured by air ultraviolet ray electron spectrometry. As a result, the work function of this transparent conductive film was 4.4 electron volts.

### [Example 5] (not according to the invention)

### (1) Production of a sputtering target, and observation as to whether or not nodules were generated

A sputtering target was produced in the same way as in the (1) in Example 4 except that the ratio among used starting materials was set as follows: 91 parts by mass of indium oxide, 6 parts by mass of gallium oxide and 3 parts by mass of germanium oxide.

Next, in the same way as in the (2) in Example 4, it was observed whether or not nodules were generated at the time of sputtering about the resultant sputtering target.

The composition and physical properties of this sputtering target, and observation results as to whether or not the nodules were generated are shown in Table 2.

### (2) Production and evaluation of a transparent conductive film

A transparent conductive film was produced in the same way as in the (3) in Example 4 except that the sputtering target obtained in the above-mentioned (1) was used.

Next, about this transparent conductive film, the transparent conductive film was evaluated in the same way as in the (4) in Example 4. The evaluation results herein are shown in Table 3.

### [Example 6] (not according to the invention)

### (1) Production of a sputtering target, and observation as to whether or not nodules were generated

A sputtering target was produced in the same way as in the (1) in Example 4 except that the ratio among used starting materials was set as follows: 93 parts by mass of indium oxide, 4 parts by mass of gallium oxide and 3 parts by mass of germanium oxide.

Next, in the same way as in the (2) in Example 4, it was observed whether or not nodules were generated at the time of sputtering about the resultant sputtering target.

The composition and physical properties of this sputtering target, and observation results as to whether or not the nodules were generated are shown in Table 2.

### (2) Production and evaluation of a transparent conductive film

A transparent conductive film was produced in the same way as in the (3) in Example 4 except that the sputtering target obtained in the above-mentioned (1) was used.

Next, about the transparent conductive film obtained herein, the transparent conductive film was evaluated in the same way as in the (4) in Example 4. The evaluation results herein are shown in Table 3.

### [Example 7]

### (1) Production of a sputtering target, and observation as to whether or not nodules were generated

A sputtering target was produced in the same way as in the (1) in Example 4 except that the ratio among used starting materials was set as follows: 95 parts by mass of indium oxide, 3 parts by mass of gallium oxide and 2 parts by mass of germanium oxide.

Next, in the same way as in the (2) in Example 4, it was observed whether or not nodules were generated at the time of sputtering about the resultant sputtering target.

The composition and physical properties of this sputtering target, and observation results as to whether or not the nodules were generated are shown in Table 2.

### (2) Production and evaluation of a transparent conductive film

A transparent conductive film was produced in the same way as in the (3) in Example 4 except that the sputtering target obtained in the above-mentioned (1) was used.

Next, about the transparent conductive film obtained herein, the transparent conductive film was evaluated in the same way as in the (4) in Example 4. The evaluation results herein are shown in Table 3.

### [Comparative Example 2]

### (1) Production of a sputtering target, and observation as to whether or not nodules were generated

A sputtering target was produced in the same way as in the (1) in Example 4 except that only indium oxide powder was used as starting material.

Next, in the same way as in the (2) in Example 4, it was observed whether or not nodules were generated at the time of sputtering about the resultant sputtering target. After the sputtering was continuously performed for 30 hours, 45 nodules were observed in a visual field of size 3 mm², which was magnified 50 times, in the surface of this sputtering target.

The composition and physical properties of the sputtering target produced herein, and observation results as to whether or not the nodules were generated are shown in Table 2.

### (2) Production and evaluation of a transparent conductive film

A transparent conductive film was produced in the same way as in the (3) in Example 4 except that the sputtering target obtained in the above-mentioned (1) was used.

Next, about the transparent conductive film obtained herein, the transparent conductive film was evaluated in the same way as in the (4) in Example 4. The evaluation results herein are shown in Table 3.

### [Comparative Example 3]

### (1) Production of a sputtering target, and observation as to whether or not nodules were generated

A sputtering target was produced in the same way as in the (1) in Example 4 except that the ratio between used materials was set as follows: 94 parts by mass of indium oxide and 6 parts by mass of gallium oxide.

Next, in the same way as in the (2) in Example 4, it was observed whether or not nodules were generated at the time of sputtering about the resultant sputtering target. After the sputtering was continuously performed for 30 hours, 24 nodules were observed in a visual field of size 3 mm², which was magnified 50 times, in the surface of this sputtering target.

The composition and physical properties of the sputtering target produced herein, and observation results as to whether or not the nodules were generated are shown in Table 2.

### (2) Production and evaluation of a transparent conductive film

A transparent conductive film was produced in the same way as in the (3) in Example 4 except that the sputtering target obtained in the above-mentioned (1) was used.

Next, about the transparent conductive film obtained herein, the transparent conductive film was evaluated in the same way as in the (4) in Example 4. The evaluation results herein are shown in Table 3.

### [Comparative Example 4]

### (1) Production of a sputtering target, and observation as to whether or not nodules were generated

A sputtering target was produced in the same way as in the (1) in Example 4 except that the ratio between used materials was set as follows: 94 parts by mass of indium oxide and 6 parts by mass of germanium oxide.

Next, in the same way as in the (2) in Example 4, it was observed whether or not nodules were generated at the time of sputtering about the resultant sputtering target. After the sputtering was continuously performed for 30 hours, 21 nodules were observed in a visual field of size 3 mm², which was magnified 50 times, in the surface of this sputtering target.

The composition and physical properties of the sputtering target produced herein, and observation results as to whether or not the nodules were generated are shown in Table 2.

### (2) Production and evaluation of a transparent conductive film

A transparent conductive film was produced in the same way as in the (3) in Example 4 except that the sputtering target obtained in the above-mentioned (1) was used.

Next, about the transparent conductive film obtained herein, the transparent conductive film was evaluated in the same way as in the (4) in Example 4. The evaluation results herein are shown in Table 3.

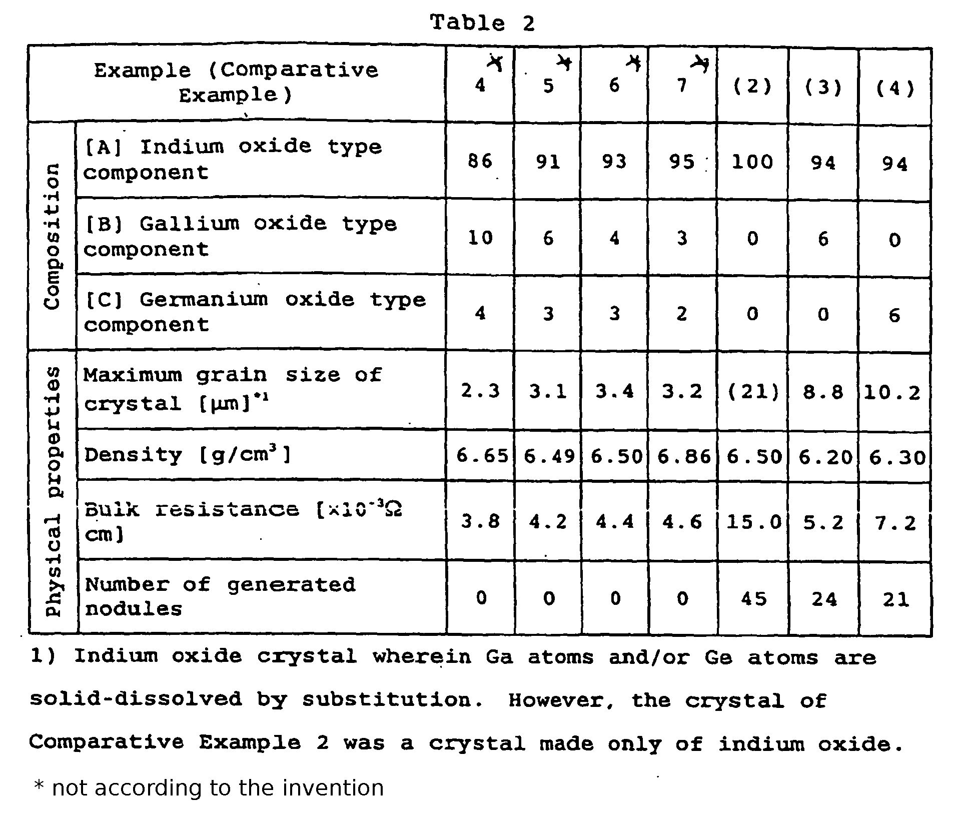

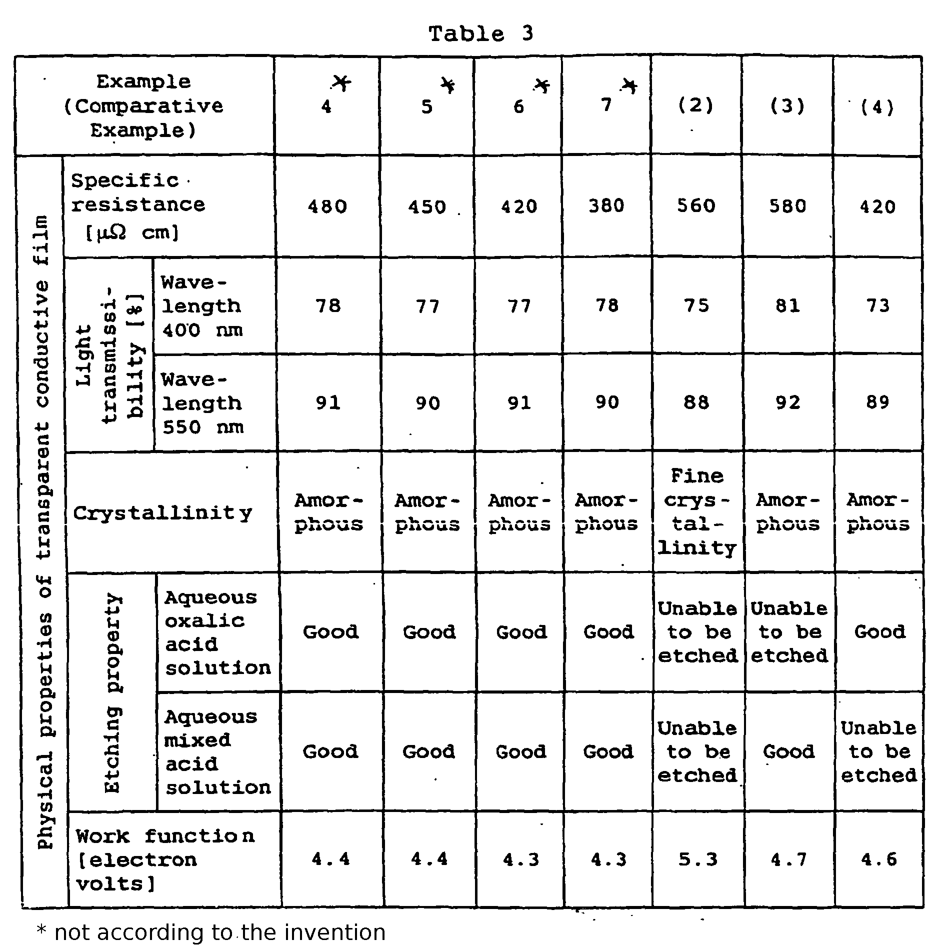

### [Example 8] (not according to the invention)

### (1) Production of a sputtering target, and observation as to whether or not nodules were generated

A sintered product was obtained in the same way as in the (1) in Example 4 except that the ratio among used starting materials was set as follows: 86 parts by mass of indium oxide, 6 parts by mass of tin oxide, 6 parts by mass of gallium oxide, and 2 parts by mass of germanium oxide. This sintered product was analyzed by EPMA. As a result, it was proved that there were indium oxide crystal wherein tin atoms were solid-dissolved by substitution, indium oxide crystal wherein gallium atoms were solid-dissolved by substitution, and indium oxide crystal wherein germanium atoms were solid-dissolved by substitution. It was also proved that there were tin oxide wherein indium atoms were solid-dissolved by substitution, gallium oxide wherein indium atoms were solid-dissolved by substitution, and germanium oxide wherein indium atoms were solid-dissolved by substitution. Next, this sintered product was worked in the same way as in the (1) in Example 4 to produce a sputtering target.

Next, in the same way as in the (2) in Example 4, it was observed whether or not nodules were generated at the time of sputtering about the resultant sputtering target.

The composition and physical properties of this sputtering target, and observation results as to whether or not the nodules were generated are shown in Table 4.

### (2) Production and evaluation of a transparent conductive film

A transparent conductive film was produced in the same way as in the (3) in Example 4 except that the sputtering target obtained in the above-mentioned (1) was used.

Next, about the transparent conductive film obtained herein, the transparent conductive film was evaluated in the same way as in the (4) in Example 4. This transparent conductive film was subjected to heat treatment at 250°C and the specific resistance thereof was measured by a four-prove method. The evaluation results herein are shown in Table 5.

### [Example 9] (not according to the invention)

### (1) Production of a sputtering target, and observation as to whether or not nodules were generated

A sputtering target was produced in the same way as in the (1) in Example 4 except that the ratio among used starting materials was set as follows: 88 parts by mass of indium oxide, 6 parts by mass of tin oxide, 4 parts by mass of gallium oxide, and 2 parts by mass of germanium oxide.

Next, in the same way as in the (2) in Example 4, it was observed whether or not nodules were generated at the time of sputtering about the resultant sputtering target.

The composition and physical properties of this sputtering target, and observation results as to whether or not the nodules were generated are shown in Table 4.

### (2) Production and evaluation of a transparent conductive film

A transparent conductive film was produced in the same way as in the (3) in Example 4 except that the sputtering target obtained in the above-mentioned (1) was used.

Next, about the transparent conductive film obtained herein, the transparent conductive film was evaluated in the same way as in the (2) in Example 8. The evaluation results herein are shown in Table 5.

### [Example10] (not according to the invention)

### (1) Production of a sputtering target, and observation as to whether or not nodules were generated

A sputtering target was produced in the same way as in the (1) in Example 4 except that the ratio among used starting materials was set as follows: 83 parts by mass of indium oxide, 8 parts by mass of tin oxide, 6 parts by mass of gallium oxide, and 3 parts by mass of germanium oxide.

Next, in the same way as in the (2) in Example 4, it was observed whether or not nodules were generated at the time of sputtering about the resultant sputtering target.

The composition and physical properties of this sputtering target, and observation results as to whether or not the nodules were generated are shown in Table 4.

### (2) Production and evaluation of a transparent conductive film

A transparent conductive film was produced in the same way as in the (3) in Example 4 except that the sputtering target obtained in the above-mentioned (1) was used.

Next, about the transparent conductive film obtained herein, the transparent conductive film was evaluated in the same way as in the (2) in Example 8. The evaluation results herein are shown in Table 5.

### [Example 11] (not according to the invention)

### (1) Production of a sputtering target, and observation as to whether or not nodules were generated

A sputtering target was produced in the same way as in the (1) in Example 4 except that the ratio among used starting materials was set as follows: 85 parts by mass of indium oxide, 8 parts by mass of tin oxide, 4 parts by mass of gallium oxide, and 3 parts by mass of germanium oxide.

Next, in the same way as in the (2) in Example 4, it was observed whether or not nodules were generated at the time of sputtering about the resultant sputtering target.

The composition and physical properties of this sputtering target, and observation results as to whether or not the nodules were generated are shown in Table 4.

### (2) Production and evaluation of a transparent conductive film

A transparent conductive film was produced in the same way as in the (3) in Example 4 except that the sputtering target obtained in the above-mentioned (1) was used.

Next, about the transparent conductive film obtained herein, the transparent conductive film was evaluated in the same way as in the (2) in Example 8. The evaluation results herein are shown in Table 5.

### [Example 12] (not according to the invention)

### (1) Production of a sputtering target, and observation as to whether or not nodules were generated

A sputtering target was produced in the same way as in the (1) in Example 4 except that the ratio among used starting materials was set as follows: 82 parts by mass of indium oxide, 8 parts by mass of tin oxide, 6 parts by mass of gallium oxide, and 4 parts by mass of germanium oxide.

Next, in the same way as in the (2) in Example 4, it was observed whether or not nodules were generated at the time of sputtering about the resultant sputtering target.

The composition and physical properties of this sputtering target, and observation results as to whether or not the nodules were generated are shown in Table 4.

### (2) Production and evaluation of a transparent conductive film

A transparent conductive film was produced in the same way as in the (3) in Example 4 except that the sputtering target obtained in the above-mentioned (1) was used.

Next, about the transparent conductive film obtained herein, the transparent conductive film was evaluated in the same way as in the (2) in Example 8. The evaluation results herein are shown in Table 5

### [Example 13] (not according to the invention)

### (1) Production of a sputtering target, and observation as to whether or not nodules were generated

A sputtering target was produced in the same way as in the (1) in Example 4 except that the ratio among used starting materials was set as follows: 84 parts by mass of indium oxide, 8 parts by mass of tin oxide, 4 parts by mass of gallium oxide, and 4 parts by mass of germanium oxide.

Next, in the same way as in the (2) in Example 4, it was observed whether or not nodules were generated at the time of sputtering about the resultant sputtering target.

The composition and physical properties of this sputtering target, and observation results as to whether or not the nodules were generated are shown in Table 4.

### (2) Production and evaluation of a transparent conductive film

A transparent conductive film was produced in the same way as in the (3) in Example 4 except that the sputtering target obtained in the above-mentioned (1) was used.

Next, about the transparent conductive film obtained herein, the transparent conductive film was evaluated in the same way as in the (2) in Example 8. The evaluation results herein are shown in Table 5.

### [Comparative Example 5]

### (1) Production of a sputtering target, and observation as to whether or not nodules were generated

A sputtering target was produced in the same way as in the (1) in Example 4 except that the ratio between used starting materials was set as follows: 90 parts by mass of indium oxide, and 10 parts by mass of tin oxide.

Next, in the same way as in the (2) in Example 4, it was observed whether or not nodules were generated at the time of sputtering about the resultant sputtering target.

The composition and physical properties of this sputtering target, and observation results as to whether or not the nodules were generated are shown in Table 6.

### (2) Production and evaluation of a transparent conductive film

A transparent conductive film was produced in the same way as in the (3) in Example 4 except that the sputtering target obtained in the above-mentioned (1) was used.

Next, about the transparent conductive film obtained herein, the transparent conductive film was evaluated in the same way as in the (2) in Example 8. The evaluation results herein are shown in Table 7.

### [Comparative Example 6]

### (1) Production of a sputtering target, and observation as to whether or not nodules were generated

A sputtering target was produced in the same way as in the (1) in Example 4 except that the ratio among used starting materials was set as follows: 90 parts by mass of indium oxide, 5 parts by mass of tin oxide, and 5 parts by mass of gallium oxide.

Next, in the same way as in the (2) in Example 4, it was observed whether or not nodules were generated at the time of sputtering about the resultant sputtering target.

The composition and physical properties of this sputtering target, and observation results as to whether or not the nodules were generated are shown in Table 6.

### (2) Production and evaluation of a transparent conductive film

A transparent conductive film was produced in the same way as in the (3) in Example 4 except that the sputtering target obtained in the above-mentioned (1) was used.

Next, about the transparent conductive film obtained herein, the transparent conductive film was evaluated in the same way as in the (2) in Example 8. The evaluation results herein are shown in Table 7.

### [Comparative Example 7]

### (1) Production of a sputtering target, and observation as to whether or not nodules were generated

A sputtering target was produced in the same way as in the (1) in Example 4 except that the ratio among used starting materials was set as follows: 90 parts by mass of indium oxide, 5 parts by mass of tin oxide, and 5 parts by mass of germanium oxide.

Next, in the same way as in the (2) in Example 4, it was observed whether or not nodules were generated at the time of sputtering about the resultant sputtering target.

The composition and physical properties of this sputtering target, and observation results as to whether or not the nodules were generated are shown in Table 6.

### (2) Production and evaluation of a transparent conductive film

A transparent conductive film was produced in the same way as in the (3) in Example 4 except that the sputtering target obtained in the above-mentioned (1) was used.

Next, about the transparent conductive film obtained herein, the transparent conductive film was evaluated in the same way as in the (2) in Example 8. The evaluation results herein are shown in Table 7.

### [Comparative Example 8]

### (1) Production of a sputtering target, and observation as to whether or not nodules were generated

A sputtering target was produced in the same way as in the (1) in Example 4 except that the ratio among used starting materials was set as follows: 70 parts by mass of indium oxide, 10 parts by mass of tin oxide, 10 parts by mass of gallium oxide, and 10 parts by mass of germanium oxide.

Next, in the same way as in the (2) in Example 4, it was observed whether or not nodules were generated at the time of sputtering about the resultant sputtering target.

The composition and physical properties of this sputtering target, and observation results as to whether or not the nodules were generated are shown in Table 6.

### (2) Production and evaluation of a transparent conductive film

A transparent conductive film was produced in the same way as in the (3) in Example 4 except that the sputtering target obtained in the above-mentioned (1) was used.

Next, about the transparent conductive film obtained herein, the transparent conductive film was evaluated in the same way as in the (2) in Example 8. The evaluation results herein are shown in Table 7.

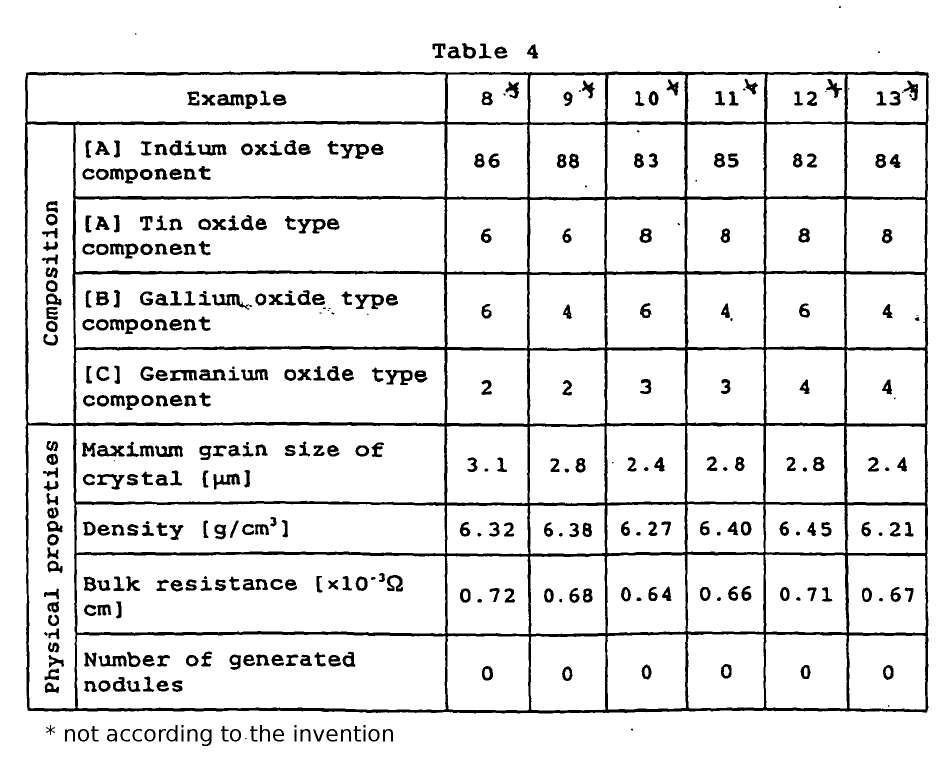

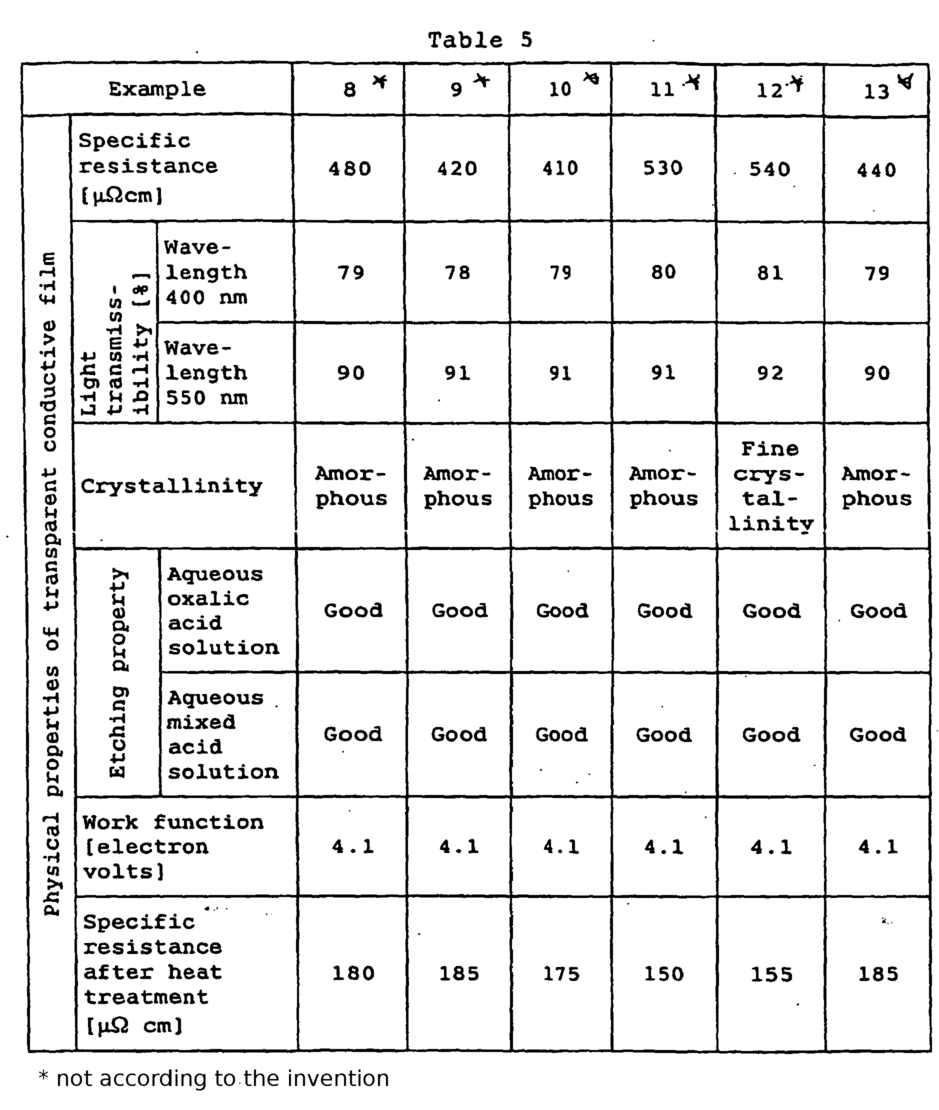

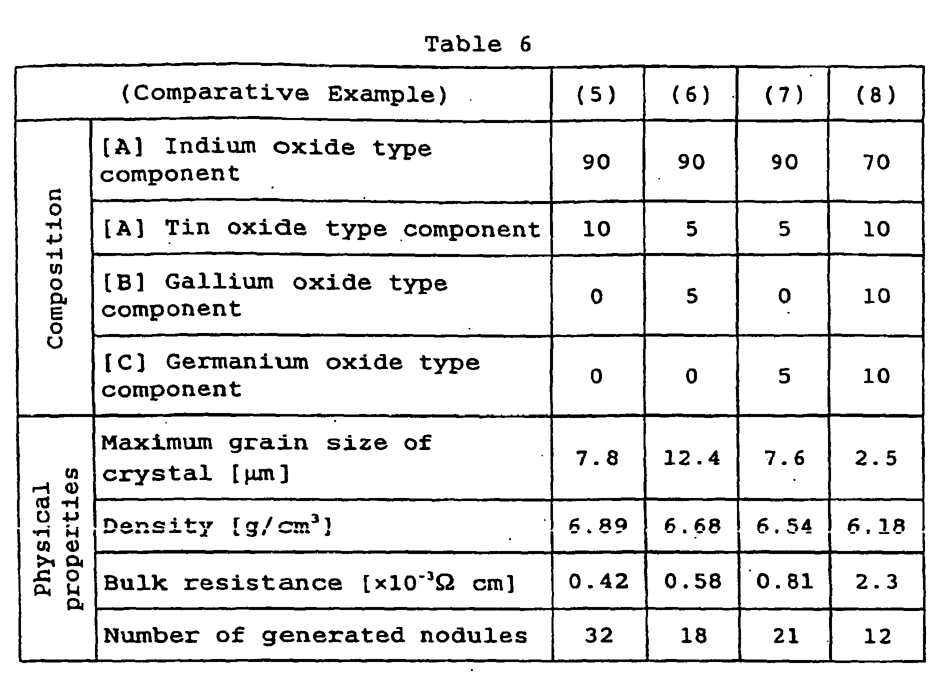

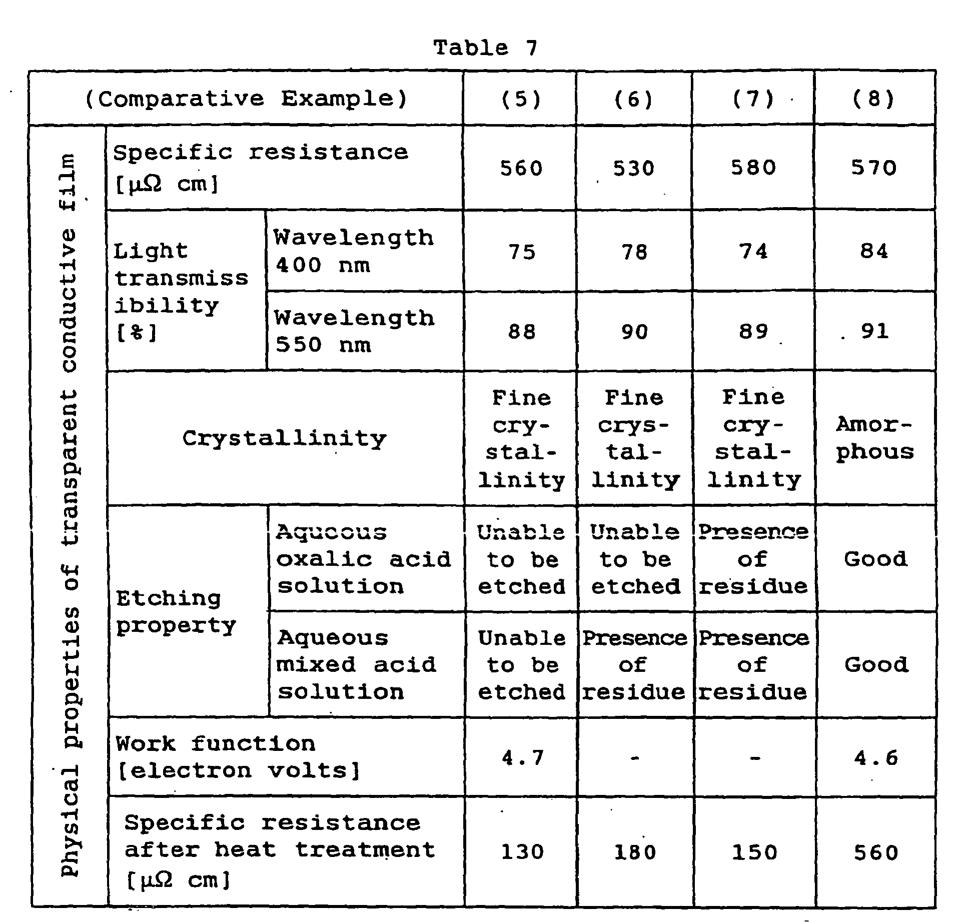

### [Example 14]

### (1) Production of a sputtering target

Indium oxide powder, gallium oxide powder and zinc oxide powder as starting materials were mixed at a ratio of 93% by mass, 4% by mass and 3% by mass and then mixed powder of these metal oxides was supplied into a wet ball mill, and they were mixed and pulverized for 10 hours to yield raw material powder having an average particle size of 1.8 to 2 µm. Next, the resultant raw material powder was dried and granulated with a spray drier, and the resultant particles were filled into a mold and molded under pressure by means of a pressing machine to yield a disc-form molded product having a diameter of 10 cm and a thickness of 5 mm.

Next, this molded product was put into a firing furnace and then sintered under the atmosphere of pressured oxygen gas for 6 hours while the sintering temperature was controlled into 1420 to 1480°C.

The sintered product obtained herein was analyzed by X-ray diffractometry and EPMA. As a result, it was proved that hexagonal crystal lamellar compounds represented by In₂O₃(ZnO)₄ and InGaZnO₄ were generated. At the center (1 position) of the disc-form sintered product and intermediate positions (4 positions) between the center on two central lines which crossed each other at the circle center and circular circumferences on the lines, that is, at 5 positions in all thereof, the sintered product was magnified 2,500 times and photographed with a scanning electron microscope. About the maximum crystal grain observed in a frame 50 µm square thereof, the maximum grain size thereof was measured. The average value of the maximum grain sizes of the maximum crystal grains present in frames at these 5 positions was calculated. As a result, it was 2.8 µm. The density of this sintered product was 6.6 g/cm³. This corresponded to 94% of the theoretical density ratio. Furthermore, the bulk resistance value of this sintered product, measured by a four-prove method, was 2.4 × 10⁻³ Ω·cm.

The thus-obtained sintered product was cut to produce a sputtering target having a diameter of about 10 cm and a thickness of about 5 mm.

### (2) Observation whether the generation of nodules was observed or not

An identification was made in the same way as in the (2) in Example 1.

As a result, the generation of nodules was not observed in the surface of the sputtering target used herein.

The composition and physical properties of the sputtering target produced herein, and observation results as to whether nodules were generated or not are shown in Table 8.

### (3) Production of a transparent conductive film

A transparent conductive film was produced in the same way as in the (3) in Example 1.

As a result, there was obtained a transparent conductive glass wherein a transparent conductive film having a film thickness of about 2,000 angstroms was formed on a glass substrate.

### (4) Evaluation of the transparent conductive film

The transparent conductive film on the transparent conductive glass, which was obtained in the above-mentioned (3), was evaluated in the same way as in the (4) in Example 4. The results are shown in Table 9.

### [Example 15]

### (1) Production of a sputtering target, and observation as to whether or not nodules were generated

A sputtering target was produced in the same way as in the (1) in Example 14 except that the ratio among used starting materials was set as follows: 91 parts by mass of indium oxide, 6 parts by mass of gallium oxide, and 3 parts by mass of zinc oxide. It was proved that a hexagonal crystal lamellar compound represented by In₂Ga₂ZnO₇ was generated in the resultant sputtering target.

Next, in the same way as in the (2) in Example 14, it was observed whether or not nodules were generated at the time of sputtering about this sputtering target.

The composition and physical properties of this sputtering target, and observation results as to whether or not the nodules were generated are shown in Table 8.

### (2) Production and evaluation of a transparent conductive film

A transparent conductive film was produced in the same way as in the (3) in Example 14 except that the sputtering target obtained in the above-mentioned (1) was used.

Next, about this transparent conductive film, the transparent conductive film was evaluated in the same way as in the (4) in Example 14. The evaluation results herein are shown in Table 9.

### [Example 16]

### (1) Production of a sputtering target, and observation as to whether or not nodules were generated

A sputtering target was produced in the same way as in the (1) in Example 14 except that the ratio among used starting materials was set as follows: 94 parts by mass of indium oxide, 4 parts by mass of gallium oxide, and 2 parts by mass of zinc oxide. It was proved that a hexagonal crystal lamellar compound represented by InGaZnO₄ was generated in the resultant sputtering target.

Next, in the same way as in the (2) in Example 14, it was observed whether or not nodules were generated at the time of sputtering about this sputtering target.

The composition and physical properties of this sputtering target, and observation results as to whether or not the nodules were generated are shown in Table 8.

### (2) Production and evaluation of a transparent conductive film

A transparent conductive film was produced in the same way as in the (3) in Example 14 except that the sputtering target obtained in the above-mentioned (1) was used.

Next, about the transparent conductive film obtained herein, the transparent conductive film was evaluated in the same way as in the (4) in Example 14. The evaluation results herein are shown in Table 9.

### [Example 17]

### (1) Production of a sputtering target, and observation as to whether or not nodules were generated.

A sputtering target was produced in the same way as in the (1) in Example 14 except that the ratio among used starting materials was set as follows: 92 parts by mass of indium oxide, 6 parts by mass of gallium oxide, and 2 parts by mass of zinc oxide. It was proved that a hexagonal crystal lamellar compound represented by In₂Ga₂ZnO₇ was generated in the resultant sputtering target.

Next, in the same way as in the (2) in Example 14, it was observed whether or not nodules were generated at the time of sputtering about this sputtering target.

The composition and physical properties of this sputtering target, and observation results as to whether or not the nodules were generated are shown in Table 8.

### (2) Production and evaluation of a transparent conductive film

A transparent conductive film was produced in the same way as in the (3) in Example 14 except that the sputtering target obtained in the above-mentioned (1) was used.

Next, about the transparent conductive film obtained herein, the transparent conductive film was evaluated in the same way as in the (4) in Example 14. The evaluation results herein are shown in Table 9.

### [Comparative Example 9]

### (1) Production of a sputtering target, and observation as to whether or not nodules were generated

A sputtering target was produced in the same way as in the (1) in Example 14 except that 90 parts by mass of indium oxide and 10 parts by mass of gallium oxide were used as starting materials. It was not proved that any hexagonal crystal lamellar compound was generated in the resultant sputtering target.

Next, in the same way as in the (2) in Example 14, it was observed whether or not nodules were generated at the time of sputtering about this sputtering target. After the sputtering was continuously performed for 30 hours, 21 nodules were observed in a visual field of size 3 mm², which was magnified 50 times, in the surface of this sputtering target.

The composition and physical properties of this sputtering target, and observation results as to whether or not the nodules were generated are shown in Table 8.

### (2) Production and evaluation of a transparent conductive film

A transparent conductive film was produced in the same way as in the (3) in Example 14 except that the sputtering target obtained in the above-mentioned (1) was used.

Next, about the transparent conductive film obtained herein, the transparent conductive film was evaluated in the same way as in the (4) in Example 14. The evaluation results herein are shown in Table 9.

### [Comparative Example 10]

### (1) Production of a sputtering target, and observation as to whether or not nodules were generated

A sputtering target was produced in the same way as in the (1) in Example 14 except that the ratio between used starting materials was set as follows: 90 parts by mass of indium oxide and 10 parts by mass of zinc oxide. It was proved that a hexagonal crystal lamellar compound represented by In₂O₃(ZnO)₇ was generated in the resultant sputtering target.

Next, in the same way as in the (2) in Example 14, it was observed whether or not nodules were generated at the time of sputtering about this sputtering target. After the sputtering was continuously performed for 30 hours, no nodule was observed in a visual field of size 3 mm², which was magnified 50 times, in the surface of this sputtering target.

The composition and physical properties of this sputtering target, and observation results as to whether or not the nodules were generated are shown in Table 8.

### (2) Production and evaluation of a transparent conductive film

A transparent conductive film was produced in the same way as in the (3) in Example 14 except that the sputtering target obtained in the above-mentioned (1) was used.

Next, about the transparent conductive film obtained herein, the transparent conductive film was evaluated in the same way as in the (4) in Example 14. The evaluation results herein are shown in Table 9.

### [Comparative Example 11]

### (1) Production of a sputtering target, and observation as to whether or not nodules were generated

A sputtering target was produced in the same way as in the (1) in Example 14 except that the ratio between used starting materials was set as follows: 95 parts by mass of indium oxide and 5 parts by mass of gallium oxide. It was not proved that any hexagonal crystal lamellar compound was generated in the resultant sputtering target.

Next, in the same way as in the (2) in Example 14, it was observed whether or not nodules were generated at the time of sputtering about this sputtering target. After the sputtering was continuously performed for 30 hours, 32 nodules were observed in a visual field of size 3 mm², which was magnified 50 times, in the surface of this sputtering target.

The composition and physical properties of this sputtering target, and observation results as to whether or not the nodules were generated are shown in Table 8.

### (2) Production and evaluation of a transparent conductive film

A transparent conductive film was produced in the same way as in the (3) in Example 14 except that the sputtering target obtained in the above-mentioned (1) was used.

Next, about the transparent conductive film obtained herein, the transparent conductive film was evaluated in the same way as in the (4) in Example 14. The evaluation results herein are shown in Table 9.

### [Comparative Example 12]

### (1) Production of a sputtering target, and observation as to whether or not nodules were generated

A sputtering target was produced in the same way as in the (1) in Example 14 except that the ratio between used starting materials was set as follows: 97 parts by mass of indium oxide and 3 parts by mass of zinc oxide. It was proved that a hexagonal crystal lamellar compound represented by In₂O₃(ZnO)₄ was generated in the resultant sputtering target.

Next, in the same way as in the (2) in Example 14, it was observed whether or not nodules were generated at the time of sputtering about the resultant sputtering target. After the sputtering was continuously performed for 30 hours, 12 nodules were observed in a visual field of size 3 mm², which was magnified 50 times, in the surface of this sputtering target.

The composition and physical properties of this sputtering target, and observation results as to whether or not the nodules were generated are shown in Table 8.

### (2) Production and evaluation of a transparent conductive film

A transparent conductive film was produced in the same way as in the (3) in Example 14 except that the sputtering target obtained in the above-mentioned (1) was used.

Next, about the transparent conductive film obtained herein, the transparent conductive film was evaluated in the same way as in the (4) in Example 14. The evaluation results herein are shown in Table 9.

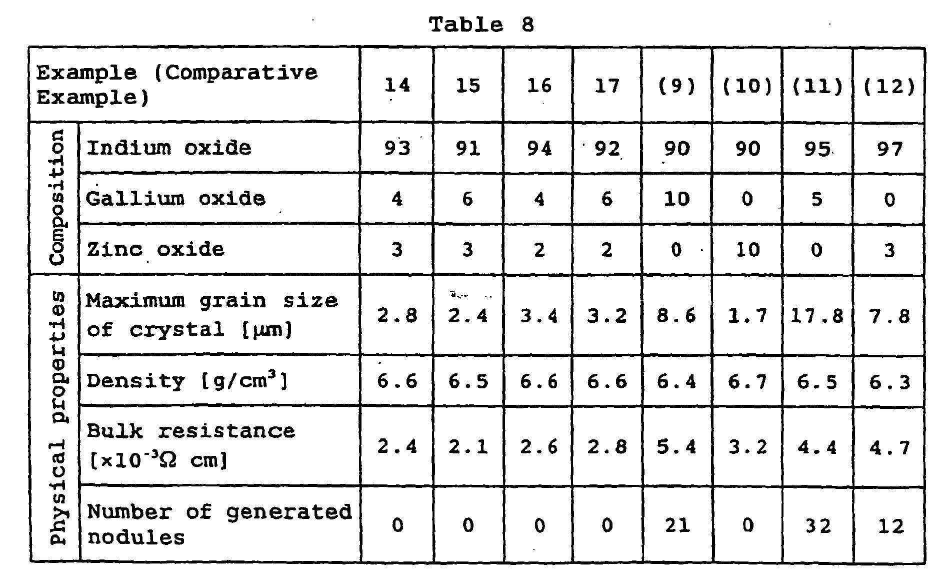

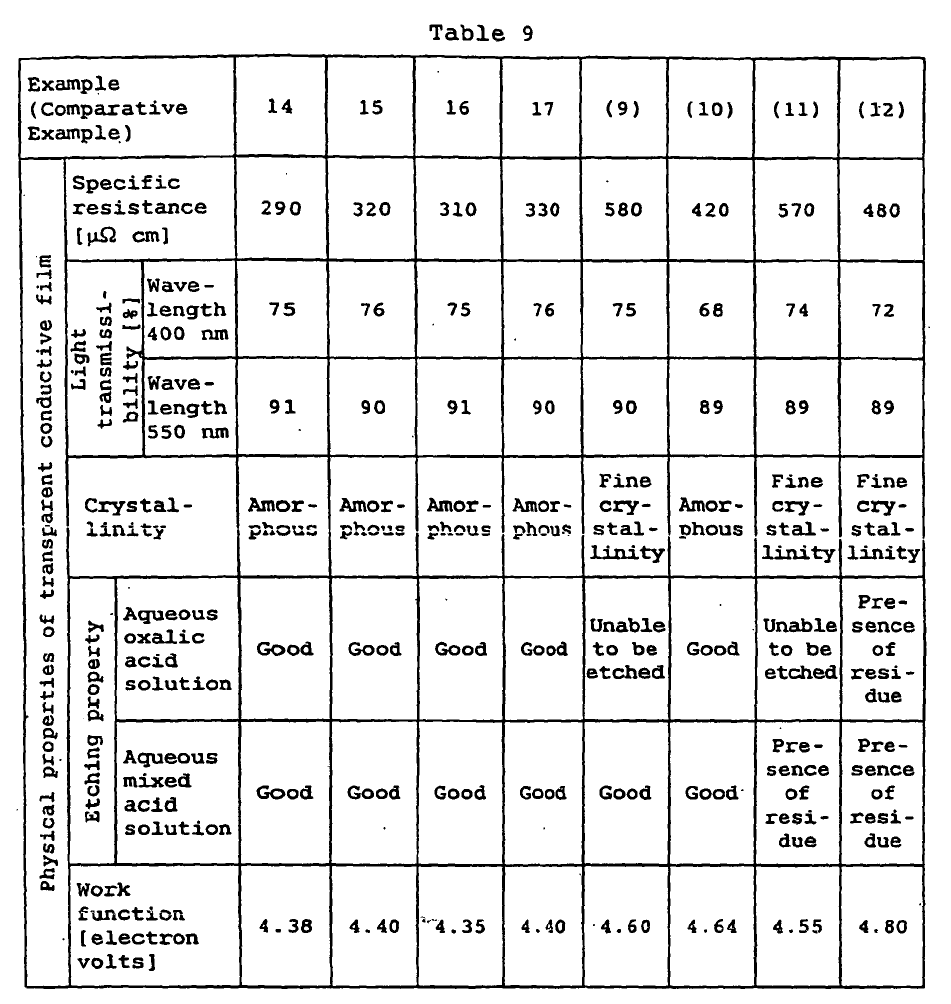

### [Example18] (not according to the invention)

### (1) Production of a sputtering target, and observation as to whether or not nodules were generated

A sputtering target was produced in the same way as in the (1) in Example 14 except that the ratio among used starting materials was set as follows: 86 parts by mass of indium oxide, 6 parts by mass of tin oxide, 6 parts by mass of gallium oxide, and 2 parts by mass of zinc oxide. It was proved that a hexagonal crystal lamellar compound represented by In₂Ga₂ZnO₇ was generated in the resultant sputtering target.

Next, in the same way as in the (2) in Example 14, it was observed whether or not nodules were generated at the time of sputtering about this sputtering target.

The composition and physical properties of this sputtering target, and observation results as to whether or not the nodules were generated are shown in Table 10.

### (2) Production and evaluation of a transparent conductive film

A transparent conductive film was produced in the same way as in the (3) in Example 14 except that the sputtering target obtained in the above-mentioned (1) was used.

Next, about the resultant transparent conductive film, the transparent conductive film was evaluated in the same way as in the (4) in Example 14. This transparent conductive film was subjected to heat treatment at 250°C, and the specific resistance thereof was measured by a four-prove method. The evaluation results herein are shown in Table 11.

### [Example 19] (not according to the invention)

### (1) Production of a sputtering target, and observation as to whether or not nodules were generated

A sputtering target was produced in the same way as in the (1) in Example 14 except that the ratio among used starting materials was set as follows: 86 parts by mass of indium oxide, 6 parts by mass of tin oxide, 4 parts by mass of gallium oxide, and 2 parts by mass of zinc oxide. It was proved that a hexagonal crystal lamellar compound represented by In₂Ga₂ZnO, was generated in the resultant sputtering target.

Next, in the same way as in the (2) in Example 14, it was observed whether or not nodules were generated at the time of sputtering about this sputtering target.

The composition and physical properties of this sputtering target, and observation results as to whether or not the nodules were generated are shown in Table 10.

### (2) Production and evaluation of a transparent conductive film

A transparent conductive film was produced in the same way as in the (3) in Example 14 except that the sputtering target obtained in the above-mentioned (1) was used.

Next, about the transparent conductive film obtained herein, the transparent conductive film was evaluated in the same way as in the (2) in Example 18. The evaluation results herein are shown in Table 11.

### [Example 20] (not according to the invention)

### (1) Production of a sputtering target, and observation as to whether or not nodules were generated

A sputtering target was produced in the same way as in the (1) in Example 14 except that the ratio among used starting materials was set as follows: 84 parts by mass of indium oxide, 8 parts by mass of tin oxide, 5 parts by mass of gallium oxide, and 3 parts by mass of zinc oxide. It was proved that a hexagonal crystal lamellar compound represented by InGaZnO₄ was generated in the resultant sputtering target.

Next, in the same way as in the (2) in Example 14, it was observed whether or not nodules were generated at the time of sputtering about this sputtering target.

The composition and physical properties of this sputtering target, and observation results as to whether or not the nodules were generated are shown in Table 10.

### (2) Production and evaluation of a transparent conductive film

A transparent conductive film was produced in the same way as in the (3) in Example 14 except that the sputtering target obtained in the above-mentioned (1) was used.

Next, about the transparent conductive film obtained herein, the transparent conductive film was evaluated in the same way as in the (2) in Example 18. The evaluation results herein are shown in Table 11.

### [Example 21] (not according to the invention)

### (1) Production of a sputtering target, and observation as to whether or not nodules were generated

A sputtering target was produced in the same way as in the (1) in Example 14 except that the ratio among used starting materials was set as follows: 85 parts by mass of indium oxide, 8 parts by mass of tin oxide, 4 parts by mass of gallium oxide, and 3 parts by mass of zinc oxide. It was proved that a hexagonal crystal lamellar compound represented by InGaZnO₄ was generated in the resultant sputtering target.

Next, in the same way as in the (2) in Example 14, it was observed whether or not nodules were generated at the time of sputtering about this sputtering target.

The composition and physical properties of this sputtering target, and observation results as to whether or not the nodules were generated are shown in Table 10.

### (2) Production and evaluation of a transparent conductive film

A transparent conductive film was produced in the same way as in the (3) in Example 14 except that the sputtering target obtained in the above-mentioned (1) was used.

Next, about the transparent conductive film obtained herein, the transparent conductive film was evaluated in the same way as in the (2) in Example 18. The evaluation results herein are shown in Table 11.

### [Example 22] (not according to the invention)

### (1) Production of a sputtering target, and observation as to whether or not nodules were generated

A sputtering target was produced in the same way as in the (1) in Example 14 except that the ratio among used starting materials was set as follows: 85 parts by mass of indium oxide, 8 parts by mass of tin oxide, 3 parts by mass of gallium oxide, and 4 parts by mass of zinc oxide. It was proved that a hexagonal crystal lamellar compound represented by InGaZn₂O₅ was generated in the resultant sputtering target.

Next, in the same way as in the (2) in Example 14, it was observed whether or not nodules were generated at the time of sputtering about this sputtering target.

The composition and physical properties of this sputtering target, and observation results as to whether or not the nodules were generated are shown in Table 10.

### (2) Production and evaluation of a transparent conductive film

A transparent conductive film was produced in the same way as in the (3) in Example 14 except that the sputtering target obtained in the above-mentioned (1) was used.

Next, about the transparent conductive film obtained herein, the transparent conductive film was evaluated in the same way as in the (2) in Example 18. The evaluation results herein are shown in Table 11.

### [Example 23] (not according to the invention)

### (1) Production of a sputtering target, and observation as to whether or not nodules were generated

A sputtering target was produced in the same way as in the (1) in Example 14 except that the ratio among used starting materials was set as follows: 86 parts by mass of indium oxide, 8 parts by mass of tin oxide, 2 parts by mass of gallium oxide, and 4 parts by mass of zinc oxide. It was proved that hexagonal crystal lamellar compounds represented by In₂O₃( ZnO)₄ and InGaZnO₄ were generated in the resultant sputtering target.

Next, in the same way as in the (2) in Example 14, it was observed whether or not nodules were generated at the time of sputtering about this sputtering target.

The composition and physical properties of this sputtering target, and observation results as to whether or not the nodules were generated are shown in Table 10.

### (2) Production and evaluation of a transparent conductive film

A transparent conductive film was produced in the same way as in the (3) in Example 14 except that the sputtering target obtained in the above-mentioned (1) was used.

Next, about the transparent conductive film obtained herein, the transparent conductive film was evaluated in the same way as in the (2) in Example 18. The evaluation results herein are shown in Table 11.

### [Comparative Example 13]

### (1) Production of a sputtering target, and observation as to whether or not nodules were generated

A sputtering target was produced in the same way as in the (1) in Example 14 except that the ratio between used starting materials was set as follows: 90 parts by mass of indium oxide and 10 parts by mass of tin oxide. It was not proved that any hexagonal crystal lamellar compound was generated in the resultant sputtering target.

Next, in the same way as in the (2) in Example 14, it was observed whether or not nodules were generated at the time of sputtering about this sputtering target. After the sputtering was continuously performed for 30 hours, 43 nodules were observed in a visual field of size 3 mm², which was magnified 50 times, in the surface of this sputtering target.

The composition and physical properties of this sputtering target, and observation results as to whether or not the nodules were generated are shown in Table 12.

### (2) Production and evaluation of a transparent conductive film

A transparent conductive film was produced in the same way as in the (3) in Example 14 except that the sputtering target obtained in the above-mentioned (1) was used.

Next, about the transparent conductive film obtained herein, the transparent conductive film was evaluated in the same way as in the (2) in Example 18. The evaluation results herein are shown in Table 13.

### [Comparative Example 14]

### (1) Production of a sputtering target, and observation as to whether or not nodules were generated

A sputtering target was produced in the same way as in the (1) in Example 14 except that the ratio among used starting materials was set as follows: 88 parts by mass of indium oxide, 9 parts by mass of tin oxide, and 3 parts by mass of zinc oxide. It was not proved that any hexagonal crystal lamellar compound was generated in the resultant sputtering target.

Next, in the same way as in the (2) in Example 14, it was observed whether or not nodules were generated at the time of sputtering about this sputtering target.

The composition and physical properties of this sputtering target, and observation results as to whether or not the nodules were generated are shown in Table 12.

### (2) Production and evaluation of a transparent conductive film

A transparent conductive film was produced in the same way as in the (3) in Example 14 except that the sputtering target obtained in the above-mentioned (1) was used.

Next, about the transparent conductive film obtained
herein, the transparent conductive film was evaluated in the same way as in the (2) in Example 18. The evaluation results herein are shown in Table 13.

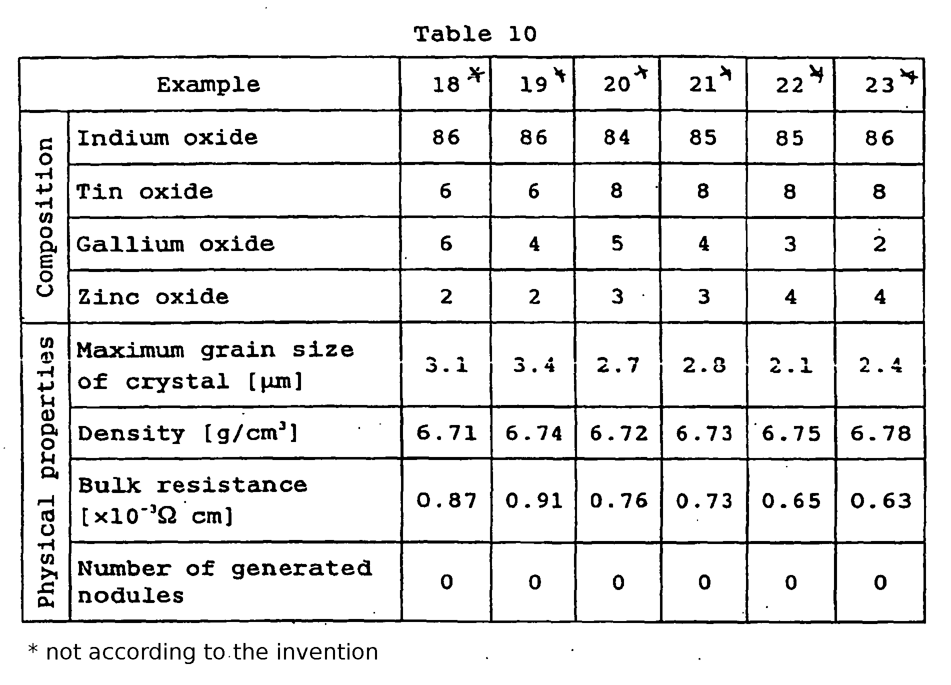

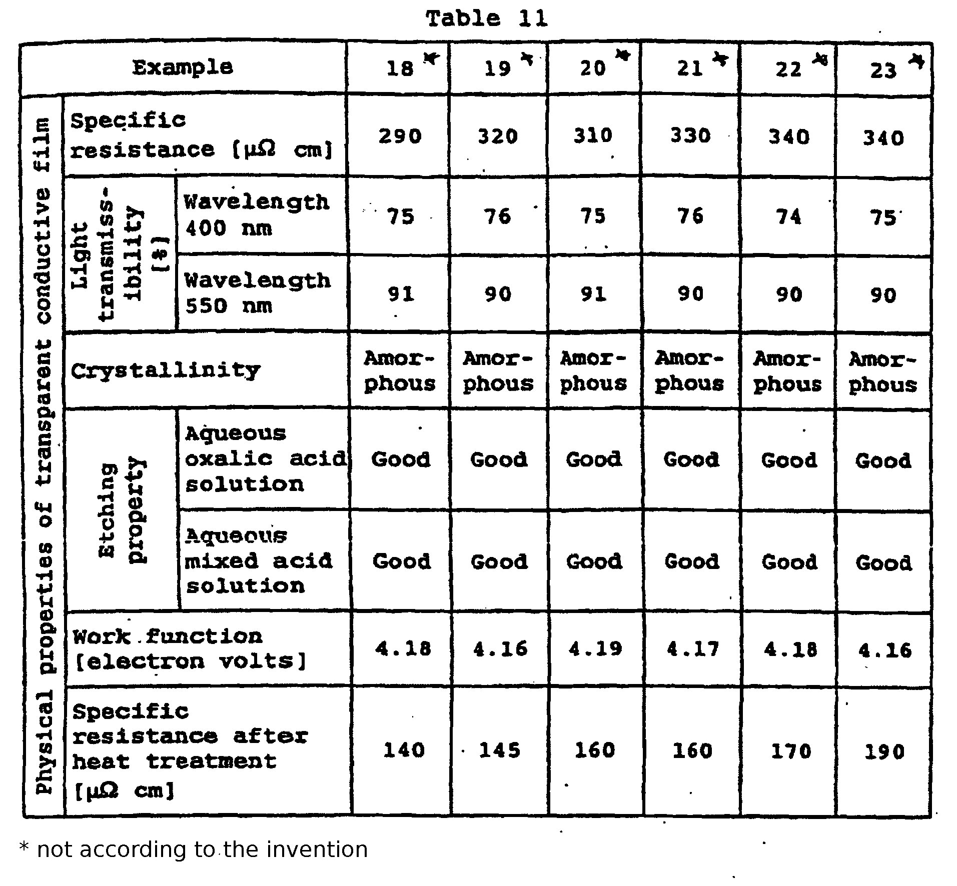

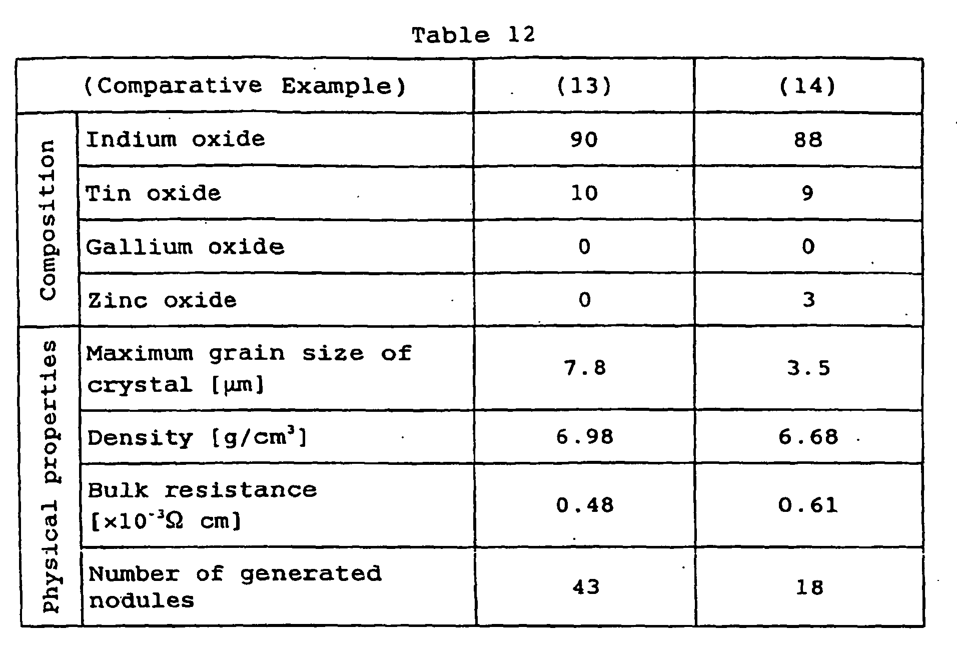

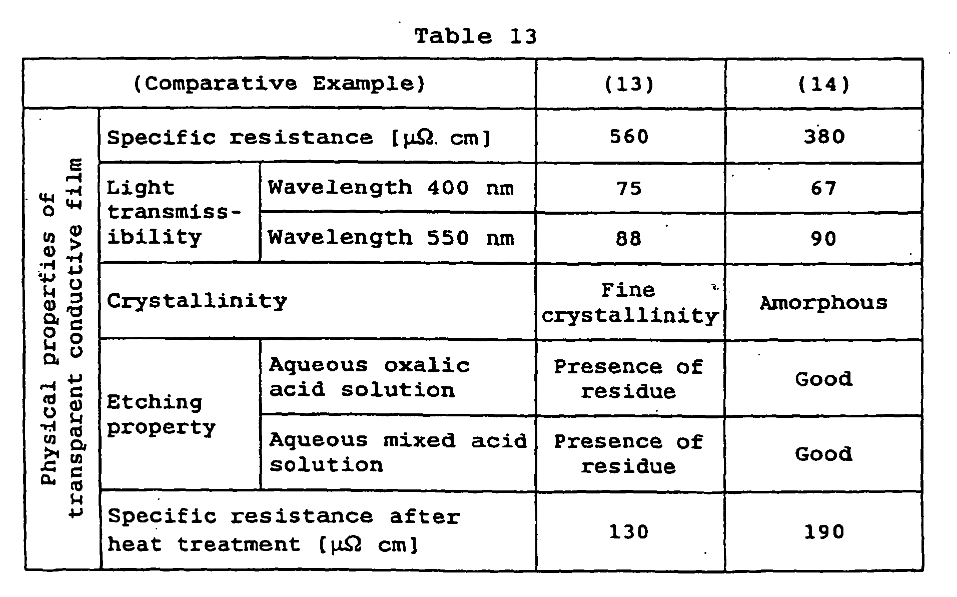

### Industrial Applicability

According to the sputtering target of the present invention, at the time of using this to form a transparent conductive film, the generation of nodules is suppressed and the formation of the film can be performed with stability and good productivity. Therefore, a transparent conductive film having a good quality can be produced with good productivity. Since the transparent conductive film of the present invention can be etching-worked with a weak acid, an electrode can be worked without producing any adverse effect on wiring material for a thin film transistor or the like.

## Claims

1. A sputtering target, comprising a sintered product of a metal oxide comprising indium oxide, gallium oxide and zinc oxide, the metal oxide comprising one or more hexagonal crystal lamellar compounds selected from In₂O₃(ZnO)ₘ, wherein m is an integer of 2 to 10, In₂Ga₂ZnO₇, InGaZnO₄, InGaZn₂O₅, InGaZn₃O₆, InGaZn₄O₇, InGaZn₅O₈, InGaZn₆O₉, and InGaZn₇O₁₀, and the sintered product having a composition of 90 to 99% by mass of the indium oxide and 1 to 10% by mass of the total of the gallium oxide and the zinc oxide, and the content by percentage of the gallium oxide being equal to or more than that of the zinc oxide.

2. The sputtering target according to claim 1, wherein the sputtering target further comprises tin oxide, and
the sintered product has a composition of 80 to 90% by mass of the indium oxide, 7 to 12% by mass of the tin oxide, and 3 to 8% by mass of the total of the gallium oxide and the zinc oxide, and
the content by percentage of the gallium oxide being equal to or more than that of the zinc oxide..

3. The sputtering target according to claim 1 or 2, wherein the maximum grain size of crystal of the hexagonal crystal lamellar compound is 5 µm or less.

4. A transparent conductive film, which is obtainable by sputtering the sputtering target of claim 1.

5. A transparent conductive film, which is obtainable by sputtering the sputtering target of claim 2.

6. The transparent conductive film according to claim 5, wherein the transparent conductive film is obtainable by heat treatment at a temperature of 230°C or higher.

7. The transparent conductive film according to claim 5, wherein the transparent conductive film is obtainable by patterning and subsequently subjecting to treatment at a temperature of 230 °C or higher.

## Patentansprüche

1. Sputtering-Target, umfassend ein gesintertes Produkt eines Metalloxids, enthaltend Indiumoxid, Galllumoxid und Zinkoxid, wobei das Metalloxid eine oder mehrere hexagonal kristalline lamellare Verbindungen ausgewählt aus In₂O₃(ZnO)ₘ, worin m ein ganzzahliger Wert von 2 bis 10 ist, In₂Ga₂ZnO₇, InGaZnO₄, JnGaZn₂O₅, InGaZn₃O₆, InGaZn₄O₇, InGaZn₅O₈, InGaZn₆O₉ und InGaZn₇O₁₀ umfasst, und worin das gesinterte Produkt eine Zusammensetzung von 90 bis 99 Gew.-% von Indiumoxid und 1 bis 10 Gew,-% der Gesamtheit von Galliumoxid und Zinkoxid hat, und worin der prozentuale Gehalt des Galliumoxids gleich oder höher als der des Zinkoxids ist.

2. Sputtering-Target gemäß Anspruch 1, worin das Sputtering-Target zusätzlich Zinnoxid enthält, und worin das gesinterte Produkt eine Zusammensetzung von 80 bis 90 Gew,-% von Indiumoxid, 7 is 12 Gew,-% von Zinnoxid und 3 bis 8 Gew,-% der Gesamtheit von Galliumoxid und Zinkoxid hat, und worin der prozentuale Gehalt des Galliumoxids gleich oder höher als der des Zinkoxids ist.

3. Sputtering-Target gemäß Anspruch 1 oder 2, worin die maximale Korngröße der Kristalle der hexagonal kristallinen lamellaren Verbindung 5 µm oder weniger ist.

4. Transparenter leitender Film, der erhältlich ist durch Sputtern des Sputtering-Targets nach Anspruch 1.

5. Transparenter leitender Film, der erhältlich ist durch Sputtern des Sputtering-Targets nach Anspruch 2.

6. Transparenter leitender Film gemäß Anspruch 5, worin der transparente leitende Film erhältlich ist durch Hitzebehandlung bei einer Temperatur von 230°C oder höher.

7. Transparenter leitender Film gemäß Anspruch 5, worin der transparente leitende Film erhältlich ist durch Strukturieren und anschließende Behandlung bei einer Temperatur von 230°C oder höher,

## Revendications

1. Cible de pulvérisation comprenant un produit fritté d'un oxyde d'un métal comprenant un oxyde d'indium, un oxyde de gallum et un oxyde de zinc, l'oxyde de métal comprenant un ou plusieurs composés lamellaires de cristaux hexagonaux sélectionnés parmi In₂O₃(ZnO)ₘ, dans laquelle m est un entier de 2 à 10, In₂Ga₂ZnO₇, InGaZnO₄, InGaZn₂O₅, InGaZn₃O₆, InGaZn₄O₇, InGaZn₅O₈, InGaZn₆O₉ et InGaZn₇O₁₀ et le produit fritté ayant une composition de 90 à 99 % en masse de l'oxyde d'indium et de 1 à 10 % en masse de la totalité de l'oxyde de gallum et de l'oxyde de zinc et la teneur en pourcentage de l'oxyde de gallum étant égal ou supérieur à cette de l'oxyde de zinc.

2. de pulvérisation selon la revendication 1, dans laquelle la cible de pulvérisation comprend en outre un oxyde d'étain et
le produit fritté a une composition de 80 à 90 % en masse de l'oxyde d'indium, de 7 à 12 % en de l'oxyde d'étain et de 3 à 8 % en masse de la totalité de l'oxyde de gallum et de l'oxyde de zinc et
la teneur en pourcentage de l'oxyde de gallum étant égal ou supérieur à cette de l'oxyde de zinc.

3. Cible de pulvérisation selon la revendication 1 ou 2, dans laquelle la taille de grain maximum des cristaux du composé lamellaire de cristaux hexagonaux est 5 µm ou moins.

4. Film conducteur transparent qui peut être obtenu par pulvérisation de la cible de pulvérisation selon la revendication 1.

5. Film conducteur transparent qui peut être pat pulvérisation de la cible de pulvérisation selon la revendication 2.

6. Film conducteur transparent selon la revendication 5, dans lequel le film conducteur transparent peut être obtenu par traitement thermique à une température de 230 °C ou plus.

7. Film conducteur transparent selon la revendication 5, dans lequel le film conducteur transparent peut être par structuration et puis par traitement à une température de °C ou plus.
